(19) Europäisches Patentamt
European Patent Office
Office européen des brevets

(11) EP 4 775 616 A1

(12) EUROPEAN PATENT APPLICATION
published in accordance with Art. 153(4) EPC

(43) Date of publication:
**15.07.2026 Bulletin 2026/29**

(21) Application number: **24862927.1**

(22) Date of filing: **06.09.2024**

(51) International Patent Classification (IPC):
***C08G 77/20*** (2006.01) ***C08F 299/08*** (2006.01)
***G02B 6/12*** (2006.01) ***G02B 6/13*** (2006.01)

(52) Cooperative Patent Classification (CPC):
**C08F 299/08; C08G 77/20; G02B 6/12; G02B 6/13**

(86) International application number:
**PCT/JP2024/032122**

(87) International publication number:
**WO 2025/053278 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.09.2023 JP 2023145239**
**07.09.2023 JP 2023145240**
**29.03.2024 JP 2024058185**
**29.03.2024 JP 2024058186**

(71) Applicant: **Mitsubishi Chemical Corporation**
**Tokyo 100-8251 (JP)**

(72) Inventors:
- **KOSUGE, Takahiro**
**Tokyo 100-8251 (JP)**
- **ANDO, Naoki**
**Tokyo 100-8251 (JP)**
- **SAITO, Takahiro**
**Tokyo 100-8251 (JP)**
- **FUJIMORI, Naomi**
**Tokyo 100-8251 (JP)**

(74) Representative: **Hoffmann Eitle**
**Patent- und Rechtsanwälte PartmbB**
**Arabellastraße 30**
**81925 München (DE)**

(54) **ORGANOPOLYSILOXANE, ORGANOPOLYSILOXANE COMPOSITION, CURED PRODUCT THEREOF, ORGANOPOLYSILOXANE FOR NEAR-INFRARED OPTICAL WAVEGUIDE, ORGANOPOLYSILOXANE COMPOSITION FOR NEAR-INFRARED OPTICAL WAVEGUIDE, CURED PRODUCT FOR NEAR-INFRARED OPTICAL WAVEGUIDE, NEAR-INFRARED OPTICAL WAVEGUIDE, NEAR-INFRARED OPTICAL TRANSMISSION MEMBER, AND NEAR-INFRARED OPTICAL WAVEGUIDE PRODUCTION METHOD**

(57) Provided is an organopolysiloxane having a specific structure and having a polymerizable alkenyl group-containing organic group and Q unit silicon ($SiO_{4/2}$), or a non-linear organopolysiloxane having a specific structure, having a polymerizable alkenyl group-containing organic group, and having no aromatic structure.

Fig. 1

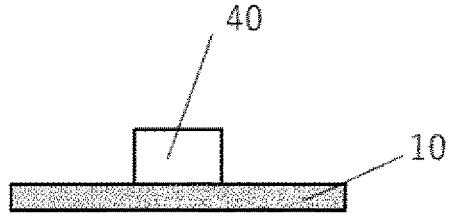




Processed by Luminess, 75001 PARIS (FR)

## Description

### Technical Field

The present invention relates to an organopolysiloxane, an organopolysiloxane composition and a cured product thereof, an organopolysiloxane for a near-infrared optical waveguide, an organopolysiloxane composition for a near-infrared optical waveguide, a cured product for a near-infrared optical waveguide, a near-infrared optical waveguide and a near-infrared optical transmission member, and a method for producing a near-infrared optical waveguide.

### Background Art

In recent years, there has been an increasing demand for higher speed, larger capacity, and lower power consumption in communication and signal transmission, and a technique of transmitting signals by light instead of conventional electricity has been attracting attention also in internal wiring of equipment. Such a short-distance optical communication technology is referred to as an optical interconnect, and as a member thereof, there is a member in which a portion of electric wiring made of copper on a printed wiring board is replaced with optical wiring formed of an optical fiber or an optical waveguide.

The optoelectric composite substrate as described above has been actively developed. In particular, in data center equipment, an optical waveguide connectable to a near-infrared single-mode quartz-based optical fiber is required. Materials used for the production of such optical waveguides are required to have, in addition to a microfabrication property by photolithography, heat resistance capable of withstanding a reflow process at the time of mounting, and low transmission loss at near-infrared wavelengths of 700 to 2500 nm, refractive indices of about 1.4 to 1.5 at near-infrared wavelengths, which are equivalent to those of core-forming materials of near-infrared single-mode quartz-based optical fibers, after being cured, in order to reduce connection loss due to reflection at the interface between a quartz-based optical fiber and an optical waveguide. In the case of single-mode waveguide, the difference in refractive index between a core material and a cladding material that form the optical waveguide is about 0.01 to 0.02, and the cladding material used around the core material is also required to have a refractive index of about 1.4 to 1.5 at near-infrared wavelengths, which is equivalent to that of the core forming material of the near-infrared single-mode quartz-based optical fiber.

As a material candidate satisfying these requirements, an organopolysiloxane having a reactive group is exemplified, but it is difficult to achieve both heat resistance after curing and a refractive index of about 1.4 to 1.5 at near-infrared wavelengths.

For example, Patent Literature 1 discloses an organopolysiloxane having an aromatic ring structure, and a resin after curing has excellent heat resistance. However, the organopolysiloxane disclosed in Patent Literature 1 has a refractive index adjusted by adjusting a ratio of an aliphatic hydrocarbon group and an aromatic hydrocarbon group, and exhibits excellent heat resistance of the resin after curing by having the aromatic ring structure. However, a material having a refractive index of less than 1.5 while maintaining heat resistance has not been obtained.

Patent Literature 2 discloses an organopolysiloxane containing fluorine atoms, and it is considered that the refractive index after curing can be made to be from 1.463 to 1.467 by adjusting the amount of fluorine atoms introduced. However, there is a concern that the heat resistance may be deteriorated, and further, adhesion to a base material may be deteriorated.

### Citation List

#### Patent Literature

Patent Literature 1: JP 2005-163009 A
Patent Literature 2: WO 2001/004186

### Summary of Invention

#### Technical Problem

In view of the problems as described above, an object of the present invention is to provide an organopolysiloxane having a polymerizable alkenyl group, which is suitable for a core material having a microfabrication property by photolithography, heat resistance capable of withstanding a reflow process at the time of mounting, and capable of reducing connection loss due to reflection at the interface between a quartz-based optical fiber and an optical waveguide,

and is suitable for a cladding material used around the core material. The present invention further relates to a method for producing a near-infrared optical waveguide including one or more layers containing a cured product of the organopolysiloxane.

Solution to Problem

As a result of intensive studies to solve the problems, the present inventors have found that an organopolysiloxane having a specific structure and constitution can solve the problems of the present application. The present invention has been completed based on the above findings.

That is, the present invention relates to the following.

(1) An organopolysiloxane represented by General Formula [1] described below:

$$(R^1R^2R^3SiO_{1/2})_{M1}(R^4R^5R^6SiO_{1/2})_{M2}\ (R^7R^8SiO_{2/2})_{D1}(R^9R^6SiO_{2/2})_{D2}\ (R^{10}SiO_{3/2})_{T1}(R^6SiO_{3/2})_{T2}(SiO_{4/2})_Q\ (O_{1/2}R^{11})_{Y1}(O_{1/2}R^6)_{Y2} \quad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;

$$0 \le M1, D1, T1, Y1, Y2;$$

$$0 < Q;$$

$$0 < M2 + D2 + T2 \le 0.25;$$

$$0.05 < Y1;$$

and

$$M1 + M2 + D1 + D2 + T1 + T2 + Q = 1].$$

(2) A non-linear organopolysiloxane represented by General Formula [21] described below and having no aromatic structure:

$$(R^{2\text{-}1}R^{2\text{-}2}R^{2\text{-}3}SiO_{1/2})_{M1}(R^{2\text{-}4}R^{2\text{-}5}R^{2\text{-}6}SiO_{1/2})_{M2}\ (R^{2\text{-}7}R^{2\text{-}8}SiO_{2/2})_{D1}(R^{2\text{-}9}R^{2\text{-}6}SiO_{2/2})_{D2}\ (R^{2\text{-}10}SiO_{3/2})_{T1}(R^{2\text{-}6}SiO_{3/2})_{T2}(SiO_{4/2})_{Q1}\ (O_{1/2}R^{2\text{-}11})_{Y1}(O_{1/2}R^{2\text{-}6})_{Y2} \quad [21]$$

[in Formula [21], $R^{2\text{-}1}$ to $R^{2\text{-}5}$ and $R^{2\text{-}7}$ to $R^{2\text{-}11}$ are each independently one or two or more groups selected from an organic group, a reactive functional group, and a hydrogen atom;
$R^{2\text{-}1}$ to $R^{2\text{-}3}$, $R^{2\text{-}7}$, $R^{2\text{-}8}$, $R^{2\text{-}10}$, and $R^{2\text{-}11}$ do not contain a polymerizable alkenyl group;
$R^{2\text{-}6}$ is one or two or more organic groups containing a polymerizable alkenyl group, which are optionally the same or different;

$$0 \le M1, D1, T1, Y1, Y2;$$

$$0 < M2 + D2 + T2 \le 0.25;$$

$$0.05 < Y1;$$

and

$$M1 + M2 + D1 + D2 + T1 + T2 + Q = 1].$$

(3) The organopolysiloxane according to Item (1) or (2) above, wherein $0.12 < M2 + D2 + T2 \leq 0.25$ in Formula [1] or Formula [21].
(4) The organopolysiloxane according to any one of Items (1) to (3) above, wherein $Y1 \leq 0.25$ in Formula [1] or Formula [21].
(5) The organopolysiloxane according to any one of Items (2) to (4) above, wherein $0 < Q$ in Formula [21].
(6) The organopolysiloxane according to any one of Items (1) to (5) above, wherein $0.04 \leq Q$ in Formula [1] or Formula [21].
(7) The organopolysiloxane according to any one of Items (1) to (6) above, wherein $M1 + M2 < 0.50$ in Formula [1] or Formula [21].
(8) The organopolysiloxane according to any one of Items (1) and (3) to (7) above, wherein the organopolysiloxane does not have an aromatic structure.
(9) The organopolysiloxane according to any one of Items (1) to (8) above, wherein in Formula [1] or Formula [21], $R^6$ or $R^{2-6}$ has, in one molecule, one or more functional groups selected from the group represented by Formulae [2] to [5] described below:

[Chem. 1]

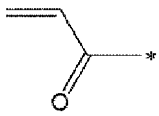 [2] 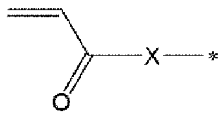 [3]

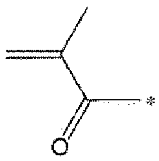 [4] 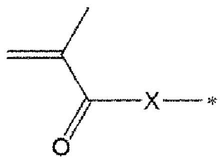 [5]

(in Formulae described above, X is a divalent organic group, and optionally contains a branched structure and/or a cyclic structure; when X is bonded to a silicon atom, an atom that is at a terminal of X and is directly bonded to silicon is a carbon atom; when X is bonded to an oxygen atom directly bonded to silicon, an atom that is at a terminal of X and is directly bonded to the oxygen atom is a carbon atom; and * represents a bond).
(10) The organopolysiloxane according to any one of Items (1) to (9) above, wherein $R^6$ or $R^{2-6}$ is a (meth) acryloyloxypropyl group.
(11) An organopolysiloxane composition containing the organopolysiloxane described in any one of Items (1) to (10) above, and at least a polymerization initiator.
(12) A cured product produced by curing the organopolysiloxane composition described in Item (11) above.
(13) A near-infrared optical waveguide produced using the organopolysiloxane composition described in Item (11) above.
(14) A near-infrared optical waveguide including a core and a cladding, wherein the core and the cladding are produced using the organopolysiloxane composition described in Item (11) above.
(15) A near-infrared optical transmission member including at least the near-infrared optical waveguide described in Item (13) above.
(16) A near-infrared optical transmission member including at least the near-infrared optical waveguide described in Item (14) above.
(17) A method for producing a near-infrared optical waveguide, the method including:

(i-1) applying a first curable polymer composition to a surface of a substrate to form a first polymer layer;
(i-2) irradiating at least one selected region of the first polymer layer with an active energy ray having a wavelength of 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane composition described in the Item (11) above.

(18) The method for producing a near-infrared optical waveguide according to Item (17) above, further including:

(i-4) coating the surface of the substrate and the core with a second curable polymer composition to form a second polymer layer; and
(i-5) curing the second polymer layer to form an upper cladding.

(19) The method for producing a near-infrared optical waveguide according to Item (18) above, wherein the second curable polymer composition is the organopolysiloxane composition described in Item (11) above.
(20) A method for producing a near-infrared optical waveguide, the method including:

(ii-1) applying a third curable polymer composition to a surface of a substrate to form a third polymer layer;
(ii-2) irradiating at least one selected region of the third polymer layer with an active energy ray having a wavelength of 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane composition described in Item (11) above.
(21) The method for producing a near-infrared optical waveguide according to Item (20) above, wherein both of the third curable polymer composition and the fourth curable polymer composition are the organopolysiloxane composition described in Item (11) above.
(22) A method for producing a near-infrared optical waveguide, the method including:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane composition described in Item (11) above.
(23) The method for producing a near-infrared optical waveguide according to Item (22) above, wherein
both of the fifth curable polymer composition and the sixth curable polymer composition are the organopolysiloxane composition described in Item (11) above.
(24) A method for producing a near-infrared optical waveguide, the method including:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane composition described in Item (11) above.
(25) The method for producing a near-infrared optical waveguide according to Item (24) above, wherein all of the fifth curable polymer composition, the sixth curable polymer composition, and the seventh curable polymer composition are the organopolysiloxane composition described in Item (11) above.

(26) An organopolysiloxane for a near-infrared optical waveguide, the organopolysiloxane having an organic group containing a polymerizable alkenyl group, and Q unit silicon ($SiO_{4/2}$), and having no aromatic structure.

(27) The organopolysiloxane for a near-infrared optical waveguide according to Item (26) above, wherein the organopolysiloxane is represented by General Formula [1] described below:

$$(R^1R^2R^3SiO_{1/2})_{M1}(R^4R^5R^6SiO_{1/2})_{M2}\ (R^7R^8SiO_{2/2})_{D1}(R^9R^6SiO_{2/2})_{D2}\ (R^{10}SiO_{3/2})_{T1}(R^6SiO_{3/2})_{T2}\ (SiO_{4/2})_Q\ (O_{1/2}R^{11})_{Y1}(O_{1/2}R^6)_{Y2} \quad [1]$$

[in Formula [1], $R^1$ to $R^5$ and $R^7$ to $R^{11}$ are each independently one or two or more groups selected from an organic group, a reactive functional group, and a hydrogen atom;

$R^1$ to $R^3$, $R^7$, $R^8$, $R^{10}$, and $R^{11}$ do not contain a polymerizable alkenyl group;

$R^6$ is one or two or more organic groups containing a polymerizable alkenyl group, which are optionally the same or different;

$$0 \leq M1, D1, T1, Y1, Y2;$$

$$0 < Q; 0 < M2 + D2 + T2;$$

and

$$M1 + M2 + D1 + D2 + T1 + T2 + Q = 1].$$

(28) The organopolysiloxane for a near-infrared optical waveguide according to Item (27) above, wherein $0 < M2 + D2 + T2 \leq 0.25$ in Formula [1].

(29) The organopolysiloxane for a near-infrared optical waveguide according to Item (27) or (28) above, wherein $0.02 \leq Y1 \leq 0.25$ in Formula [1].

(30) The organopolysiloxane for a near-infrared optical waveguide according to any one of Items (27) to (29) above, wherein $0.04 \leq Q$ in Formula [1].

(31) The organopolysiloxane for a near-infrared optical waveguide according to any one of Items (27) to (30) above, wherein $M1 + M2 < 0.50$ in Formula [1].

(32) The organopolysiloxane for a near-infrared optical waveguide according to any one of Items (27) to (31) above, wherein in Formula [1], $R^6$ has, in one molecule, one or two or more functional groups selected from the group represented by Formulae [2] to [5] described below:

[Chem. 2]

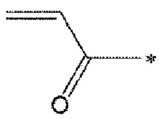 [2] 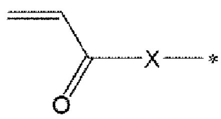 [3]

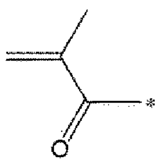 [4] 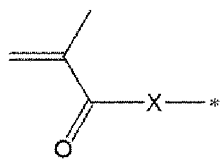 [5]

(wherein X is a divalent organic group that optionally contains a branched structure and/or a cyclic structure; when a silicon atom is bonded to X, an atom that is at a terminal of X and is directly bonded to silicon is a carbon atom; when an oxygen atom directly bonded to silicon is bonded to X, an atom that is at a terminal of X and is directly bonded to the oxygen atom is a carbon atom; and * represents a bond).

(33) The organopolysiloxane for a near-infrared optical waveguide according to any one of Items (27) to (32) above, wherein $R^6$ is a (meth)acryloyloxypropyl group.

(34) An organopolysiloxane composition for a near-infrared optical waveguide, the organopolysiloxane composition containing the organopolysiloxane for a near-infrared optical waveguide described in any one of Items (26) to (33) above, and at least a polymerization initiator.

(35) A cured product for a near-infrared optical waveguide, the cured product being produced by curing the organopolysiloxane composition for a near-infrared optical waveguide described in Item (34) above.
(36) A near-infrared optical waveguide produced using the organopolysiloxane composition for a near-infrared optical waveguide described in Item (34) above.
(37) A near-infrared optical waveguide including a core and a cladding, wherein the core and the cladding are produced using the organopolysiloxane composition for a near-infrared optical waveguide described in Item (34) above.
(38) A near-infrared optical transmission member including at least the near-infrared optical waveguide described in Item (36) above.
(39) A near-infrared optical transmission member including at least the near-infrared optical waveguide described in Item (37) above.
(40) A method for producing a near-infrared optical waveguide, the method including:

(i-1) applying a first curable polymer composition to a surface of a substrate to form a first polymer layer;
(i-2) irradiating at least one selected region of the first polymer layer with an active energy ray having a wavelength of 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane composition for a near-infrared optical waveguide described in Item (34) above.
(41) The method for producing a near-infrared optical waveguide according to Item (40) above, further including:

(i-4) coating the surface of the substrate and the core with a second curable polymer composition to form a second polymer layer; and
(i-5) curing the second polymer layer to form an upper cladding.

(42) The method for producing a near-infrared optical waveguide according to Item (41) above, wherein the second curable polymer composition is the organopolysiloxane composition for a near-infrared waveguide described in Item (34) above.
(43) A method for producing a near-infrared optical waveguide, the method including:

(ii-1) applying a third curable polymer composition to a surface of a substrate to form a third polymer layer;
(ii-2) irradiating at least one selected region of the third polymer layer with an active energy ray having a wavelength of 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane composition for a near-infrared waveguide described in Item (34) above.
(44) The method for producing a near-infrared optical waveguide according to Item (43) above, wherein both of the third curable polymer composition and the fourth curable polymer composition are the organopolysiloxane composition for a near-infrared waveguide described in Item (34) above.
(45) A method for producing a near-infrared optical waveguide, the method including:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane composition for a near-infrared optical waveguide described in Item (34) above.

(46) The method for producing a near-infrared optical waveguide according to Item (45) above, wherein both of the fifth curable polymer composition and the sixth curable polymer composition are the organopolysiloxane composition for a near-infrared optical waveguide described in Item (34) above.

(47) A method for producing a near-infrared optical waveguide, the method including:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane composition for a near-infrared optical waveguide described in Item (34) above.

(48) The method for producing a near-infrared optical waveguide according to Item (47) above, wherein all of the fifth curable polymer composition, the sixth curable polymer composition, and the seventh curable polymer composition are the organopolysiloxane composition for a near-infrared optical waveguide described in Item (34) above.

## Advantageous Effects of Invention

According to the present invention, there can be provided an organopolysiloxane having a polymerizable alkenyl group, which is suitable for a core material having a microfabrication property by photolithography, heat resistance capable of withstanding a reflow process at the time of mounting, and capable of reducing connection loss due to reflection at the interface between a quartz-based optical fiber and an optical waveguide, and is suitable for a cladding material used around the core material.

## Brief Description of Drawings

FIG. 1 is a schematic cross-sectional view of an optical waveguide in which a core is formed on a substrate.
FIG. 2 is a schematic cross-sectional view of an optical waveguide in which a core and an upper cladding are formed on a substrate.
FIG. 3 is a schematic cross-sectional view of an optical waveguide in which a lower cladding and a core are formed on a substrate.
FIG. 4 is a schematic cross-sectional view of an optical waveguide in which a lower cladding, a core, and an upper cladding are formed on a substrate.

## Description of Embodiments

Hereinafter, the present invention will be described in detail. The following description is embodiments of the present invention, and the present invention is not limited thereto as long as it does not exceed the gist thereof.

In the present invention, the term "(meth)acryl" means "one or both of acryl and methacryl".

In the present invention, a numerical range represented by the term "to" means a range including the numerical values written before and after the word "to" as the lower limit value and the upper limit value, respectively.

## Organopolysiloxane

Hereinafter, a first aspect and a second aspect of the organopolysiloxane of the present invention will be described. The first aspect and the second aspect may be collectively referred to as "both aspects".

First Aspect

In the first aspect of the present invention (hereinafter may be abbreviated as the present first aspect), the organopolysiloxane has an organic group containing a polymerizable alkenyl group and Q unit silicon ($SiO_{4/2}$), and is used for forming a near-infrared optical waveguide.

The use of an organopolysiloxane containing a polymerizable alkenyl group in the structure enables a cured product to be produced more easily with a polymerization initiator. In addition, the inclusion of Q unit silicon enables the refractive index of the cured product at near-infrared wavelengths to range from 1.4 to 1.5, and furthermore, can improve heat resistance to provide reflow resistance. It is surprising that the above effect can be obtained by including the silicon Q unit structure, which is a multibranched component and is generally avoided in most cases, because gelling proceeds during synthesis when it is introduced.

It is preferred that the organopolysiloxane of the present first aspect does not contain an aromatic structure because the refractive index of the cured product will otherwise become high.

Second Aspect

In the second aspect of the present invention (hereinafter may be abbreviated as the present second aspect), the organopolysiloxane has an organic group containing a polymerizable alkenyl group and does not have an aromatic structure, and is used for forming a near-infrared optical waveguide.

The use of the organopolysiloxane containing a polymerizable alkenyl group in the structure enables a cured product to be produced more easily with a polymerization initiator. In addition, the absence of an aromatic structure enables the refractive index of the cured product at near-infrared wavelengths to range from 1.40 to 1.48.

Furthermore, the organopolysiloxane of the present invention preferably has Q unit silicon ($SiO_{4/2}$) because the cured product can achieve improved heat resistance to have reflow resistance while maintaining the refractive index at near-infrared wavelengths of 1.40 to 1.48.

The organopolysiloxane of the present first aspect is represented by Formula [1] described below.

$$(R^1R^2R^3SiO_{1/2})_{M1}(R^4R^5R^6SiO_{1/2})_{M2}\ (R^7R^8SiO_{2/2})_{D1}(R^9R^6SiO_{2/2})_{D2}\ (R^{10}SiO_{3/2})_{T1}(R^6SiO_{3/2})_{T2}(SiO_{4/2})_Q\ (O_{1/2}R^{11})_{Y1}(O_{1/2}R^6)_{Y2} \qquad [1]$$

In Formula [1] above, $R^1$ to $R^5$ and $R^7$ to $R^{11}$ are each independently one or two or more groups selected from an organic group, a reactive functional group, and a hydrogen atom.

$R^1$ to $R^3$, $R^7$, $R^8$, $R^{10}$, and $R^{11}$ do not contain a polymerizable alkenyl group.

Meanwhile, $R^6$ is one or two or more organic groups containing a polymerizable alkenyl group, which may be the same or different.

The organopolysiloxane of the present second aspect is a non-linear organopolysiloxane represented by General Formula [21] described below and having no aromatic structure.

$$(R^{2-1}R^{2-2}R^{2-3}SiO_{1/2})_{M1}(R^{2-4}R^{2-5}R^{2-6}SiO_{1/2})_{M2}\ (R^{2-7}R^{2-8}SiO_{2/2})_{D1}(R^{2-9}R^{2-6}SiO_{2/2})_{D2}\ (R^{2-10}SiO_{3/2})_{T1}(R^{2-6}SiO_{3/2})_{T2}(SiO_{4/2})_Q\ (O_{1/2}R^{2-11})_{Y1}(O_{1/2}R^{2-6})_{Y2} \qquad [21]$$

In Formula [21] above, $R^{2-1}$ to $R^{2-5}$ and $R^{2-7}$ to $R^{2-11}$ are each independently one or two or more groups selected from an organic group, a reactive functional group, and a hydrogen atom, and do not have an aromatic structure.

$R^{2-1}$ to $R^{2-3}$, $R^{2-7}$, $R^{2-8}$, $R^{2-10}$, and $R^{2-11}$ do not contain a polymerizable alkenyl group.

$R^{2-6}$ is one or two or more organic groups not having an aromatic structure and containing a polymerizable alkenyl group, which may be the same or different.

In the present second aspect, the organopolysiloxane is non-linear. This means that at least one of a T unit or a Q unit is present.

The coefficients in Formula [1] or Formula [21] respectively represent the following values:

$$0 \leq M1, D1, T1, Y1, Y2;$$

$$0 < M2 + D2 + T2 \leq 0.25;$$

$$0.05 < Y1;$$

$$M1 + M2 + D1 + D2 + T1 + T2 + Q = 1;$$

and

$0 < Q$ in Formula [1].

In General Formula [1] or Formula [21], the coefficients M1, M2, D1, D2, T1, T2, and Q represent the proportions (on a molar basis) of the respective structures, where M1 + M2 + D1 + D2 + T1 + T2 + Q = 1.

In General Formula [1] or Formula [21], the coefficients Y1 and Y2 represent relative content proportions of $(O_{1/2}R^{11})$ and $(O_{1/2}R^{6})$, where M1 + M2 + D1 + D2 + T1+ T2 + Q = 1.

In General Formula [1] or Formula [21], the coefficients M1 and M2 represent the proportion of so-called M unit silicon ($SiO_{1/2}$) (hereinafter may be referred to simply as "M unit") in which one oxygen atom is bonded to a silicon atom. Similarly, D1 and D2 represent the proportion of D unit silicon ($SiO_{2/2}$) (hereinafter may be referred to simply as "D unit") in which two oxygen atoms are bonded to a silicon atom, T1 and T2 represent the proportion of T unit silicon ($SiO_{3/2}$) (hereinafter may be referred to simply as "T unit") in which three oxygen atoms are bonded to a silicon atom, and Q represents the proportion of Q unit silicon ($SiO_{4/2}$) (hereinafter may be referred to simply as "Q unit") in which four oxygen atoms are bonded to a silicon atom.

M2, D2, and T2 represent the proportions of the M unit, the D unit, and the T unit, respectively, in which $R^6$ or $R^{2-6}$, i.e., an organic group containing a polymerizable alkenyl group, is bonded to a silicon atom.

Y1 means the content proportion of alkoxy groups bonded to silicon or silanol groups, and Y2 means the content proportion of organic groups containing polymerizable alkenyl groups bonded to silicon.

$0 \leq M1$, $0 \leq D1$, $0 \leq T1$, $0 \leq Y1$, and $0 \leq Y2$ mean that M1, D1, T1, Y1, and Y2 are each 0 or more, and may be 0, i.e., the corresponding structural unit may be absent.

$0 < M2 + D2 + T2$ means that the organopolysiloxane of the present invention has at least one of M unit, D unit, or T unit in which $R^6$ or $R^{2-6}$, i.e., an organic group containing a polymerizable alkenyl group, is bonded to a silicon atom.

Q Unit

The Q unit silicon ($SiO_{4/2}$) is an essential constituent unit in the present first aspect, and is not an essential constituent unit in the present second aspect.

The Q unit is in a form in which silicon is most oxidized, and the inclusion of the Q unit in the structure of the organopolysiloxane can increase the heat resistance of the cured product. The Q unit is also contained in quartz, and the use of an organopolysiloxane composition having the Q unit described below enables production of a cured product having a refractive index close to that of the core material of a near-infrared single-mode quartz-based optical fiber.

In the present first aspect, the coefficient Q, which is the content proportion of the Q unit, is more than 0, preferably 0.04 or more, more preferably 0.10 or more, and still more preferably 0.30 or more.

In the present second aspect, the coefficient Q, which is the content proportion of the Q unit, is preferably 0 or more, more preferably 0.04 or more, still more preferably 0.25 or more, yet still more preferably 0.30 or more, and even yet still more preferably 0.35 or more, and may be more than 0.38.

Meanwhile, when the amount of Q unit is large, the organopolysiloxane solidifies or becomes highly viscous, leading to a deteriorated handling property. Therefore, the upper limit of the coefficient Q in both aspects is usually 0.65 or less, more preferably 0.6 or less, and still more preferably 0.45 or less.

As described above, the Q unit in the present first aspect is preferably $0 < Q \leq 0.65$, more preferably $0.04 \leq Q \leq 0.6$, and still more preferably $0.04 \leq Q \leq 0.45$, and the Q unit in the present second aspect is preferably $0 \leq Q \leq 0.65$, more preferably $0.04 \leq Q \leq 0.6$, and still more preferably $0.04 \leq Q \leq 0.45$.

M2 + D2 + T2

In the organopolysiloxane of both aspects, when $0 < M2 + D2 + T2$, the organopolysiloxane contains a polymerizable alkenyl group, and a cured product can be easily produced using a composition containing a polymerization initiator described below. When the content proportion of the polymerizable alkenyl group is too low, poor curing may occur during the production of a cured product, and the compatibility with other components added to the organopolysiloxane composition described below will be deteriorated. From the above viewpoint, $0.10 \leq M2 + D2 + T2$ is preferable, and $0.12 \leq M2 + D2 + T2$ is more preferable.

In the present invention, the upper limit of M2 + D2 + T2 has two embodiments in both aspects as follows.

In a first embodiment, from the viewpoint of the microfabrication property, the heat resistance, and the effect of reducing connection loss due to reflection at the interface between a quartz-based optical fiber and an optical waveguide, a range of $M2 + D2 + T2 \leq 0.75$ is preferable, and a range of $M2 + D2 + T2 \leq 0.60$ is more preferable. When M2 + D2 + T2 is set within the above range, the content proportion of the polymerizable alkenyl group can be appropriately maintained, and an

appropriate crosslinking density that prevents the cured product from becoming brittle can be achieved.

In a second embodiment, the range is $M2 + D2 + T2 \leq 0.25$ from the viewpoint of achieving an organopolysiloxane having superior heat resistance and a refractive index in the near-infrared wavelength region close to those of the core materials of quartz-based optical fibers in addition to the above effects.

As described above, in the first embodiment of both aspects, the range is preferably $0 < M2 + D2 + T2 \leq 0.75$, more preferably $0.10 \leq M2 + D2 + T2 \leq 0.75$, and still more preferably $0.12 \leq M2 + D2 + T2 \leq 0.60$, and in the second embodiment of both aspects, the range is $0 < M2 + D2 + T2 \leq 0.25$, preferably $0.10 \leq M2 + D2 + T2 \leq 0.25$, more preferably $0.12 \leq M2 + D2 + T2 \leq 0.25$, still more preferably $0.12 < M2 + D2 + T2 \leq 0.25$, and yet still more preferably $0.12 < M2 + D2 + T2 \leq 0.20$.

$O_{1/2}R^{11}$ and $O_{1/2}R^{2\text{-}11}$

The ($O_{1/2}R^{11}$) in the present first aspect and the ($O_{1/2}R^{2\text{-}11}$) in the present second aspect are structures not having a polymerizable alkenyl group and having a group selected from the group consisting of an organic group, a reactive functional group, and a hydrogen atom, and specifically, are an alkoxy group bonded to silicon or a silanol group, and each of these can control the viscosity of the organopolysiloxane and can adjust the viscosity so as to be suitable for molding. The silanol group has an effect of increasing the viscosity, and replacing the silanol group with an alkoxy group has an effect of reducing the viscosity. When the total amount of the alkoxy group and the silanol group is small, the amount of the terminal group having high mobility is small, and the siloxane skeleton becomes a cage type, resulting in a rigid structure and increased viscosity. On the contrary, when the total amount of the alkoxy group and the silanol group is large, the amount of the terminal group having high mobility is large, and the siloxane skeleton becomes a flexible random structure that is not a cage type, thus resulting in decreased viscosity.

Coefficient Y1

The coefficient Y1 as the content proportion of ($O_{1/2}R^{11}$) in the present first aspect and ($O_{1/2}R^{2\text{-}11}$) in the present second aspect is 0 or a positive value. Y1 represents the total content proportion of the silanol group and the alkoxy group in the organopolysiloxane, as defined in $R^{11}$ and $R^{2\text{-}11}$.

In a third embodiment of both aspects, the range of the coefficient Y1 is more than 0.05, and preferably 0.07 or more, from the viewpoint of the synthesis of the organopolysiloxane described below, the viscosity adjustment required for the production of the organopolysiloxane composition, and the toughness of the cured product.

In a fourth embodiment of both aspects, the range of the coefficient Y1 is usually 0 or more, preferably 0.02 or more, more preferably 0.025 or more, and still more preferably 0.03 or more, from the viewpoint of the synthesis of the organopolysiloxane described below, the viscosity adjustment required for the production of the organopolysiloxane composition, and the toughness of the cured product.

Meanwhile, from the viewpoint of storage stability, the upper limit of the coefficient Y1 is usually 0.25 or less, preferably 0.2 or less, and more preferably 0.1 or less.

Thus, in the third embodiment of both aspects, the range is $0.05 < Y$, preferably $0.05 < Y \leq 0.25$, more preferably $0.05 < Y1 \leq 0.2$, still more preferably $0.07 \leq Y1 \leq 0.1$.

In the fourth embodiment of both aspects, the range is preferably $0.02 \leq Y1 \leq 0.25$, more preferably $0.025 \leq Y1 \leq 0.2$, and still more preferably $0.03 \leq Y1 \leq 0.1$.

Y1 is expressed as a value relative to $M1 + M2 + D1 + D2 + T1 + T2 + Q = 1$.

Coefficient Y2

The coefficient Y2 is the content proportion of the organic group containing a polymerizable alkenyl group bonded to silicon via an oxygen atom, and preferably $Y2 > 0.25$. When $Y2 > 0.25$, the compatibility with other resins is improved. Since a compound in which a polymerizable alkenyl group is bonded to silicon is hydrolyzed by water and is likely to be eliminated, the water absorption rate may be increased. Thus, it is preferred to use a method that is less likely to be affected by moisture.

Meanwhile, in environments affected by moisture, when Y2 is large, the cured product is likely to become brittle due to moisture. Thus, the range is preferably $Y2 < 0.4$, more preferably $Y2 < 0.3$, and still more preferably $Y2 < 0.2$. It is also preferred that Y2 be 0.

Y2 is expressed as a value relative to $M1 + M2 + D1 + D2 + T1 + T2 + Q = 1$.

Coefficient M1

The M unit not having $R^6$ or $R^{2\text{-}6}$ is not an essential constituent element in the organopolysiloxane of both aspects, but is preferably contained therein. Therefore, the coefficient M1, which is the proportion of the M unit not having $R^6$ or $R^{2\text{-}6}$,

is preferably M1 > 0. Substitution of the alkoxy group and the silanol group of the organopolysiloxane with the M unit can improve the storage stability of the organopolysiloxane and reduce the viscosity to a low level. From the viewpoint of the storage stability, the coefficient M1 is preferably 0.09 or more, and is usually 0.6 or less, preferably 0.5 or less, and more preferably 0.4 or less.

M1 + M2

In both aspects of the present invention, M1 + M2, which is a coefficient of the M unit, is preferably less than 0.50 ($M1 + M2 < 0.50$). When the value of the coefficient M1 + M2 is within the above range, the storage stability of the organopolysiloxane can be improved, the viscosity can be reduced to a low level, and the compatibility with other components added to the organopolysiloxane composition as described below can be favorably maintained. M1 + M2 is more preferably 0.49 or less.

Coefficient D1

The D unit not having $R^6$ or $R^{2-6}$ is not an essential constituent element in the organopolysiloxane of both aspects, but introduction of the D unit can impart toughness to the cured product. However, when the content proportion of the D unit not having $R^6$ or $R^{2-6}$ is too high, the heat resistance of the cured product will decrease. Therefore, the coefficient D1, which is the proportion of the D unit not having $R^6$ or $R^{2-6}$, is preferably $D1 \leq 0.7$, more preferably $D1 \leq 0.6$, and still more preferably $D1 \leq 0.3$.

Coefficient T1

The T unit not having $R^6$ or $R^{2-6}$ is not an essential constituent element in the organopolysiloxane of both aspects, but introduction of the T unit can improve the compatibility with other components added to the organopolysiloxane composition as described below. However, when the content proportion of the T unit not having $R^6$ or $R^{2-6}$ is too high, poor curing is likely to occur due to steric hindrance of the organic group introduced. Thus, the coefficient T1, which is the proportion of the T unit not having $R^6$ or $R^{2-6}$, is preferably $T1 \leq 0.5$, more preferably $T1 \leq 0.4$, and still more preferably $T1 \leq 0.3$.

The first to fourth embodiments in both aspects described above can be optionally combined as long as the effects of the present invention are not impaired.

Accordingly, the coefficients in Formula [1] or Formula [21] above are, for example, as follows.

In one aspect of both aspects, $0 < Q \leq 0.65$, $0 < M2 + D2 + T2 \leq 0.25$, $0.05 < Y1 \leq 0.25$, $Y2 < 0.4$, $0 < M1 + M2 \leq 0.6$, $D1 \leq 0.7$, and $T1 \leq 0.5$ are preferable, $0.04 \leq Q \leq 0.60$, $0.10 \leq M2 + D2 + T2 \leq 0.25$, $0.05 < Y1 \leq 0.2$, $Y2 < 0.3$, $0.09 \leq M1 + M2 \leq 0.5$, $D1 \leq 0.6$, and $T1 \leq 0.4$ are more preferable, and $0.04 \leq Q \leq 0.45$, $0.10 \leq M2 + D2 + T2 \leq 0.20$, $0.07 \leq Y1 \leq 0.1$, $Y2 < 0.2$, $0.09 \leq M1 + M2 \leq 0.4$, $D1 \leq 0.3$, and $T1 \leq 0.3$ are still more preferable.

In another aspect of both aspects, $0 < Q \leq 0.65$, $0 < M2 + D2 + T2 \leq 0.75$, $0.02 \leq Y1 \leq 0.25$, $Y2 < 0.4$, $0 < M1 + M2 \leq 0.6$, $D1 \leq 0.7$, and $T1 \leq 0.5$ are preferable, $0.04 \leq Q \leq 0.60$, $0.10 \leq M2 + D2 + T2 \leq 0.75$, $0.025 \leq Y1 \leq 0.20$, $Y2 < 0.3$, $0.09 \leq M1 + M2 \leq 0.5$, $D1 \leq 0.6$, and $T1 \leq 0.4$ are more preferable, and $0.04 \leq Q \leq 0.45$, $0.12 \leq M2 + D2 + T2 \leq 0.6$, $0.03 \leq Y1 \leq 0.1$, $Y2 < 0.2$, $0.09 \leq M1 + M2 \leq 0.4$, $D1 \leq 0.3$, and $T1 \leq 0.3$ are even more preferable.

$R^6$ or $R^{2-6}$

$R^6$ in the present first aspect and $R^{2-6}$ in the present second aspect are an organic group substituted with a polymerizable alkenyl group. Specific examples include those having an acryloyl group, a methacryloyl group, a vinyl group, or a styryl group, but $R^6$ and $R^{2-6}$ are preferably those having, in one molecule, one or two or more functional groups selected from the group represented by Formulae [2] to [5] described below.

[Chem. 3]

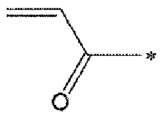 [2] 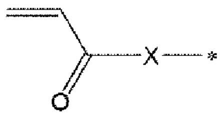 [3]

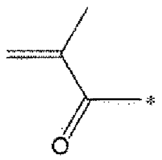 [4] 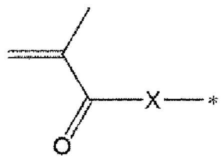 [5]

(In Formulae above, * represents a bond.)

More preferably, $R^6$ and $R^{2-6}$ have, in one molecule, at least one functional group selected from the group consisting of an acryloyloxypropyl group, an acryloyloxyoctyl group, a methacryloyloxypropyl group, and a methacryloyloxyoctyl group. Of these, it is particularly preferred that $R^6$ and $R^{2-6}$ have, in one molecule, an acryloyloxypropyl group and/or a methacryloyloxypropyl group.

In Formulae [3] and [5], X is a divalent organic group that may contain a branched structure and/or a cyclic structure. X may contain any one selected from the group consisting of oxygen, nitrogen, phosphorus, sulfur, and halogen, in addition to carbon and hydrogen. When a silicon atom is bonded to X, an atom that is at a terminal of X and is directly bonded to silicon is preferably a carbon atom. When an oxygen atom directly bonded to silicon is bonded to X, an atom that is at a terminal of X and is directly bonded to the oxygen atom is preferably a carbon atom. For example, a divalent hydrocarbon group having 1 to 20 carbons that may contain a branched structure or a cyclic structure, polyalkylene glycol, or the like is suitably used.

The organopolysiloxane of the present second aspect is required not to have an aromatic structure. In the organopolysiloxane of the present first aspect, since the refractive index of the cured product will otherwise become high as well, the proportion of the aromatic group in the total of all groups bonded to the silicon atom is preferably 20 mol% or less, more preferably 15 mol% or less, still more preferably 10 mol% or less, yet still more preferably 5 mol% or less, and especially preferably 1 mol% or less. It is particularly preferred to use an organopolysiloxane not containing an aromatic structure. When the organopolysiloxane of the present first aspect has an aromatic group, the lower limit thereof is not limited as long as the effects of the present invention are not impaired, but may be, for example, 0.01 mol% or 0.1 mol%.

The content of the aromatic group can be confirmed by $^1$H-NMR or $^{29}$Si-NMR. The expression "not having at all" means that an aromatic group can be identified in an NMR chart, but the NMR chart does not have a distinct peak that can be confirmed as such.

In both aspects, each of the units constituting the M, D, and T units is not required to be all identical. For example, the unit in which the coefficient is M1, i.e., ($R^1R^2R^3SiO_{1/2}$) of the present first aspect and ($R^{2-1}R^{2-2}R^{2-3}SiO_{1/2}$) of the present second aspect, may have different structures; for example, some $R^1$ and $R^{2-1}$ are hydrogen atoms, while other $R^1$ and $R^{2-1}$ are methyl groups. This is also common to other R and X.

$R^1$ to $R^5$ and $R^7$ to $R^{10}$ in the present first aspect, and $R^{2-1}$ to $R^{2-5}$ and $R^{2-7}$ to $R^{2-10}$ in the present second aspect are each independently a group selected from an organic group, a reactive functional group, and a hydrogen atom, and in the present second aspect, the group does not have an aromatic structure.

As the above organic group, $R^1$ to $R^5$, $R^7$ to $R^{10}$, $R^{2-1}$ to $R^{2-5}$, and $R^{2-7}$ to $R^{2-10}$ are each independently preferably an alkyl group such as a methyl group, an ethyl group, a propyl group, an isopropyl group, a butyl group, a sec-butyl group, a tert-butyl group, an octyl group, or a cyclohexyl group, or an ether group such as a polyalkylene glycol group, and more preferably a methyl group or a hydrogen atom.

$R^1$ to $R^5$ and $R^7$ to $R^{10}$ in the present first aspect may be an aromatic group such as a phenyl group, a naphthyl group, a carbazole group, a phenethylene group, or a furanyl group.

$R^{11}$ and $R^{2-11}$ do not contain a polymerizable alkenyl group and represent a group selected from an organic group having 1 to 20 carbons and a hydrogen atom, and $R^{2-11}$ does not have an aromatic structure. Of these, a methyl group is preferred.

As the above reactive functional group, an SiH group, a hydroxyl group such as an alcohol, a carboxyl group, an aldehyde group, an epoxy group, and the like are suitable. However, $R^1$ to $R^3$, $R^7$, $R^8$, $R^{10}$, $R^{2-1}$ to $R^{2-3}$, $R^{2-7}$, $R^{2-8}$, and $R^{2-10}$ do not contain a polymerizable alkenyl group. The reason for this definition is that, for example, when $R^1$ to $R^3$ and $R^{2-1}$ to $R^{2-3}$ are organic groups containing a polymerizable alkenyl group, the M1 proportion portion and the M2 proportion portion cannot be distinguished from each other.

Meanwhile, this restriction does not apply to $R^4$, $R^5$, $R^{2-4}$, and $R^{2-5}$ in the M2 proportion portion, because even when they are organic groups containing a polymerizable alkenyl group, such a problem does not occur. For the same

reason, $R^7$, $R^8$, $R^{10}$, $R^{2-7}$, $R^{2-8}$, and $R^{2-10}$ are defined as not containing a polymerizable alkenyl group in the D1 proportion portion and the T1 proportion portion as well.

The organopolysiloxane of both aspects described above is particularly suitable for near-infrared optical waveguide applications. Therefore, in another embodiment of the present invention, an organopolysiloxane for a near-infrared optical waveguide is also provided. Each of the aspects, requirements, and the like of the organopolysiloxane for a near-infrared optical waveguide is as described above for the organopolysiloxane of both aspects.

In the present description, the term "organopolysiloxane" shall mean both an organopolysiloxane and an organopolysiloxane for a near-infrared optical waveguide.

Method for Producing Organopolysiloxane

The method for producing the organopolysiloxane of both aspects is not particularly limited as long as the organopolysiloxane represented by Formula [1] and the organopolysiloxane represented by Formula [21] can be produced. For example, any production method may be used, such as a method of simultaneously condensing one type or a plurality of types of a disiloxane compound, a disilazane compound, and a hydrolysate thereof, an alkoxysilane compound and a hydrolysate thereof, and a partially hydrolyzed condensate; a method of condensing a chlorosilane compound or a hydrolysate thereof, or a partially hydrolyzed condensate; a method of ring-opening polymerization of a cyclic siloxane compound; or a method of chain polymerization including anionic polymerization. A plurality of the production methods may be used in combination. The method for introducing the polymerizable alkenyl group is not particularly limited, and may be any introduction method, such as a method of simultaneously condensing one type or a plurality of types of an alkoxysilane compound, a disiloxane compound, and a disilazane compound each having a polymerizable alkenyl group, a hydrolysate thereof, and a partially hydrolyzed condensate thereof; and a method of converting a reactive organic group introduced into an organopolysiloxane into a polymerizable alkenyl group by a chemical technique. These methods may be used in combination.

Hereinafter, raw materials that can be used in the production of the organopolysiloxane of the present invention by hydrolytic condensation are exemplified below.

M Unit Source

Examples of the M unit source that can be used in both aspects include trimethylsilanol, trimethylmethoxysilane, hexamethyldisiloxane, hexamethyldisilazane, dimethylsilanol, dimethylmethoxysilane, tetramethyldisiloxane, tetramethyldisilazane, dimethylvinylsilanol, dimethylvinylmethoxysilane, 1,3-divinyltetramethyldisiloxane, 1,3-divinyltetramethyldisilazane, dimethyl(meth)acryloyloxypropylsilanol, dimethyl(meth)acryloyloxypropylmethoxysilane, 1,3-di(meth)acryloyloxypropyltetramethyldisiloxane, 3-(meth)acryloyloxypropyldimethylmethoxysilane, 1,3-bis((meth)acryloyloxypropyl)-1,1,3,3-tetramethyldisiloxane, tetramethyldisiloxane, dimethylglycidyloxypropylmethoxysilane, 1,3-bis(3-glycidyloxypropyl)tetramethyldisiloxane, and a group of compounds in which a halogen is bonded instead of a silanolic hydroxyl group or an alkoxy group in the compounds containing the silanolic hydroxyl group or the alkoxy group among the compounds listed above. In the present first aspect, further examples that can be used include 1,3-diphenyltetramethyldisiloxane, 1,3-diphenyltetramethyldisilazane, dimethylphenylsilanol, dimethylmethoxyphenylsilane, 1,4-bis(dimethylmethoxysilyl)benzene, 1,4-bis(dimethylethoxysilyl)benzene, and a group of compounds in which a halogen is bonded instead of a silanolic hydroxyl group or an alkoxy group in a compound containing the silanolic hydroxyl group or the alkoxy group among the compounds listed above. In particular, hexamethyldisiloxane can be suitably used in both aspects. It is preferred to use a compound not containing an aromatic structure also in the present first aspect because the refractive index of the cured product will otherwise become high.

D Unit Source

Examples of the D unit source that can be used in both aspects include dimethyldisilanol, dimethyldimethoxysilane, 3-(meth)acryloyloxypropyldimethoxymethylsilane, 3-glycidoxypropylmethyldimethoxysilane, and a group of compounds in which a halogen is bonded instead of a silanolic hydroxyl group or an alkoxy group in the compounds listed above, and polymers thereof. In the present first aspect, further examples that can be used include diphenyldisilanol, diphenyldimethoxysilane, methyldimethoxyphenylsilane, diethoxymethylphenylsilane, methylphenyldisilanol, 1,4-bis(methyldimethoxysilyl)benzene, 1,4-bis(methyldiethoxysilyl)benzene, dimethoxy(methyl)(3,3,3-trifluoropropyl)silane, and a group of compounds in which a halogen is bonded instead of a silanolic hydroxyl group or an alkoxy group in the compounds listed above, and polymers thereof. In particular, dimethyldimethoxysilane can be particularly suitably used in both aspects. It is preferred to use a compound not containing an aromatic structure also in the present first aspect because the refractive index of the cured product will otherwise become high.

T Unit Source

Examples of the T unit source that can be used in both aspects include trimethoxysilane, methyltrimethoxysilane, ethyltrimethoxysilane, propyltrimethoxysilane, hexyltrimethoxysilane, decyltrimethoxysilane, and other $C_1$ to $C_{20}$ long-chain alkoxy group-modified trimethoxysilane, vinyltrimethoxysilane, 3,3,3-trifluoropropyltrimethoxysilane, 3-(meth)acryloyloxypropyltrimethoxysilane, 8-(meth)acryloyloxyoctyltrimethoxysilane, p-styryltrimethoxysilane, 3-glycidyloxypropyltrimethoxysilane, 8-glycidyloxyoctyltrimethoxysilane, 2-(3,4-epoxycyclohexyl)ethyltrimethoxysilane, and, in addition to these methoxysilane compounds, ethoxysilane and other alkoxysilane compounds, silanol compounds, chlorosilane compounds, hydrosilylsilane compounds, and polymers thereof. In the present first aspect, further examples that can be used include phenyltrimethoxysilane, 1,4-bis(trimethoxysilyl)benzene, and alkoxysilane compounds, silanol compounds, chlorosilane compounds, and hydrosilylsilane compounds thereof, and polymers thereof. In particular, 3-methacryloyloxypropyltrimethoxysilane, 8-methacryloyloxyoctyltrimethoxysilane, 3-acryloyloxypropyltrimethoxysilane, and 8-acryloyloxyoctyltrimethoxysilane can be suitably used in both aspects. It is preferred to use a compound not containing an aromatic structure also in the present first aspect because the refractive index of the cured product will otherwise become high.

Q Unit Source

Examples of the Q unit source that can be used in both aspects include alkoxysilanes such as tetrachlorosilane, tetramethoxysilane, tetraethoxysilane, tetraisopropoxysilane, tetrapropoxysilane, tetrabutoxysilane, tetrapentyloxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane and monomethoxymonoethoxymonopropoxymonobutoxysilane; Methyl Silicate MS51, MS56, MS57, and MS60 available from Mitsubishi Chemical Corporation as tetramethoxysilane oligomers; and Ethyl Silicate Oligomers ES40 and ES48 available from Tama Chemicals Co., Ltd. as tetraethoxysilane oligomers. In particular, Methyl Silicate MS51 is suitable. In the present first aspect, in addition to the above, aryloxysilanes such as tetraphenyloxysilane and monomethoxytriphenyloxysilane can also be used. However, in the present first aspect as well, it is more preferred to use those not containing an aromatic structure because the refractive index of the cured product will otherwise become high.

In both aspects, the above M, D, T and Q unit sources may be used alone or in combination of two or more types thereof.

As a catalyst for hydrolytic condensation of these silicon raw materials, an acid catalyst, a base catalyst, or an inorganic salt can be used. In particular, an acid catalyst can be suitably used.

Examples of the acid catalyst include hydrochloric acid, sulfuric acid, trifluoroacetic acid, acetic acid, methacrylic acid, and acrylic acid. In particular, hydrochloric acid can be suitably used.

Examples of the base catalyst include ammonia, hexamethyldisilazane, triethylamine, tetraethylammonium hydroxide, diazabicycloundecene, potassium hydroxide, sodium hydroxide, barium hydroxide, potassium carbonate, and sodium carbonate. In particular, potassium hydroxide is suitable.

Examples of the inorganic salt include sodium chloride, potassium chloride, magnesium chloride, calcium chloride, sodium bromide, potassium bromide, magnesium bromide, and calcium bromide. In particular, sodium chloride is suitable.

Examples of the solvent used in the hydrolytic condensation reaction include tetrahydrofuran, toluene, methanol, ethanol, isopropanol, hexane, and heptane. In particular, tetrahydrofuran is preferred. Depending on the solubility of a product, two or more types of solvents may be used, and in particular, a mixed liquid of toluene and methanol or a mixed liquid of tetrahydrofuran and methanol is preferred.

The alkoxy group or silanol group remaining without undergoing hydrolytic condensation may be substituted with an organic acid or an alcohol as necessary. Examples of the organic acid that can be used include acetic acid, acrylic acid, and methacrylic acid. As an alcohol not containing a polymerizable alkenyl group, methanol, ethanol, propanol, butyl alcohol, pentanol, hexanol, heptanol, or a structural isomer thereof can be used. As an alcohol containing a polymerizable alkenyl group, 2-hydroxyethyl acrylate or 2-hydroxyethyl methacrylate can be used. From the viewpoint of stability, 2-hydroxyethyl acrylate or 2-hydroxyethyl methacrylate is preferred.

When the organopolysiloxane has a rigid structure such as a complete cage-type silsesquioxane, the cured product is hard and brittle. Thus, it is preferred that the organopolysiloxane does not have a complete cage-type structure. The silsesquioxane may be any silsesquioxane as long as it is not a complete cage-type silsesquioxane, and may contain,

for example, a random structure or a ladder structure as a higher-order structure to the extent that the effects of the present invention are not impaired.

Water

The amount of water used for the hydrolysis is preferably 0.5 equivalents or more, more preferably 0.8 equivalents or more, and still more preferably 1.1 equivalents or more, relative to the total amount of the alkoxy groups contained in the MDTQ unit sources. As an example of the type of water, water contained in commercially available hydrochloric acid or the like may be used, or water purified by distillation or an ion exchange resin may be used.

Organopolysiloxane Composition

The organopolysiloxane composition of the present embodiment is used for forming a near-infrared optical waveguide. The composition may contain, in addition to the organopolysiloxane of the present first aspect or the organopolysiloxane of the present second aspect as described above, a monofunctional polymerizable alkenyl compound, a polyfunctional polymerizable alkenyl compound, and/or an alkenyl-based polymer, or the like to the extent that the below-described properties of the cured product produced from the composition are not impaired.

The composition may further contain a polymerization initiator for polymerizing and easily curing the organopolysiloxane and the polymerizable alkenyl compound. Although the organopolysiloxane or organopolysiloxane composition can be cured by electron beam irradiation or the like without using a polymerization initiator, a large amount of energy is required for curing. Therefore, in a preferred aspect of the present embodiment, the organopolysiloxane composition contains at least a polymerization initiator in addition to the above organopolysiloxane.

In addition to the above, the composition may contain a chain transfer agent, an antioxidant, an ultraviolet absorber, a light stabilizer, a leveling agent, a rheology modifier, an adhesion aid such as a silane coupling agent, a dye, an antifoaming agent, a sensitizer, other components, a solvent, and the like to the extent that the below-described properties of the cured product produced from the composition are not impaired.

Hereinafter, components that may be contained in the organopolysiloxane composition will be described.

Monofunctional Polymerizable Alkenyl Compound

Specific examples of the monofunctional polymerizable alkenyl compound include:

(meth)acrylates containing a carboxy group, such as (meth)acrylic acid, 2-(meth)acryloyloxyethyl succinate, 2-(meth)acryloyloxyethyl maleate, 2-(meth)acryloyloxyethyl phthalate, and 2-(meth)acryloyloxyethyl hexahydrophthalate;
(meth)acrylates having a hydroxyl group, such as 2-hydroxyethyl (meth)acrylate, 2-hydroxypropyl (meth)acrylate, 2-hydroxybutyl (meth)acrylate, 4-hydroxybutyl (meth)acrylate, and 6-hydroxyhexyl (meth)acrylate;
alkyl (meth)acrylates such as methyl (meth)acrylate, ethyl (meth)acrylate, propyl (meth)acrylate, n-butyl (meth)acrylate, i-butyl (meth)acrylate, tert-butyl (meth)acrylate, pentyl (meth)acrylate, heptyl (meth)acrylate, 2-ethylhexyl (meth)acrylate, n-octyl (meth)acrylate, isooctyl (meth)acrylate, n-nonyl (meth)acrylate, isononyl (meth)acrylate, decyl (meth)acrylate, lauryl (meth)acrylate, tridecyl (meth)acrylate, and stearyl (meth)acrylate;
(meth)acrylates containing an alicyclic structure, such as cyclohexyl (meth)acrylate, dicyclopentenyl (meth)acrylate, 2-dicyclopentenoxyethyl (meth)acrylate, isobornyl (meth)acrylate, dicyclopentanyl (meth)acrylate, adamantyl (meth)acrylate, and 4-tert-butylcyclohexyl (meth)acrylate;
(meth)acrylates containing an aromatic ring structure, such as phenyl (meth)acrylate, benzyl (meth)acrylate, phenoxyethyl (meth)acrylate, phenoxydiethylene glycol (meth)acrylate, phenoxypolyethylene glycol (meth)acrylate, nonylphenoxypolyethylene glycol (meth)acrylate, phenoxypolypropylene glycol (meth)acrylate, phenylphenyl (meth)acrylate, phenylphenoxyethyl (meth)acrylate, phenoxybenzyl (meth)acrylate, phenylbenzyl (meth)acrylate, naphthyl (meth)acrylate, and (1-naphthyl)methyl (meth)acrylate;
(meth)acrylates containing a heterocyclic structure, such as tetrahydrofurfuryl (meth)acrylate, glycidyl (meth)acrylate, and (meth)acryloylmorpholine;
alkoxy (meth)acrylates such as methoxyethyl (meth)acrylate, ethoxyethyl (meth)acrylate, and butoxyethyl (meth)acrylate;
3-(meth)acryloxypropyltrimethoxysilane, 3-(meth)acryloxypropyltriethoxysilane, 2-(meth)acryloyloxyethyl acid phosphate, trifluoroethyl (meth)acrylate, heptadecafluorodecyl (meth)acrylate, and 2-(meth)acryloyloxyethyl isocyanate;
styrene derivatives such as styrene, $\alpha$-methylstyrene, 2-vinylpyridine, 4-vinylpyridine, 1,1-diphenylethylene, and aromatic hydrogen-substituted compounds thereof; and
vinyl compounds such as vinyl acetate, vinyl octanoate, vinyl decanoate, vinyl hexanoate, acrylonitrile, and vinyl

benzoate.

It is preferred to use a compound not containing an aromatic structure because the refractive index of the cured product will otherwise become high.

Polyfunctional Polymerizable Alkenyl Compound

Specific examples of the polyfunctional polymerizable alkenyl compound include:

alkylene glycol di(meth)acrylates such as ethylene glycol di(meth)acrylate, propylene glycol di(meth)acrylate, butylene glycol di(meth)acrylate, 1,6-hexanediol di(meth)acrylate, 1,9-nonanediol di(meth)acrylate, 1,10-decanediol di(meth)acrylate, and neopentyl glycol di(meth)acrylate;
polyalkylene glycol di(meth)acrylates such as polyethylene glycol di(meth)acrylate, polypropylene glycol di(meth) acrylate, and polybutylene glycol di(meth)acrylate;
di(meth)acrylates having an alicyclic structure, such as cyclohexanedimethanol di(meth)acrylate, tricyclodecanedimethanol di(meth)acrylate, ethoxylated hydrogenated bisphenol A di(meth)acrylate, propoxylated hydrogenated bisphenol A di(meth)acrylate, and adamantanediol di(meth)acrylate;
bifunctional (meth)acrylates such as polycarbonate diol di(meth)acrylate, polyester diol di(meth)acrylate, ethoxylated bisphenol A di(meth)acrylate, propoxylated bisphenol A di(meth)acrylate, 9,9-bis(4-acryloyloxyethoxyphenyl)fluorene, and polyurethane di(meth)acrylate;
trifunctional (meth)acrylates such as trimethylolpropane tri(meth)acrylate, ethoxylated isocyanuric acid tri(meth) acrylate, and ε-caprolactone-modified tris((meth)acryloxyethyl) isocyanurate;
tetrafunctional (meth)acrylates such as ditrimethylolpropane tetra(meth)acrylate;
pentafunctional (meth)acrylates such as dipentaerythritol penta(meth)acrylate;
polyfunctional monomers including hexafunctional (meth)acrylates such as dipentaerythritol hexa(meth)acrylate; and
1,4-divinylbenzene and 1,3-divinylbenzene.

It is preferred to use a compound not containing an aromatic structure because the refractive index of the cured product will otherwise become high.

Alkenyl-Based Polymer

The alkenyl-based polymer is a polymer containing 50 mass% or more of an alkenyl monomer unit in the composition. In the present description, the term "unit" means a repeating unit constituting a polymer. The polymerizable alkenyl compound may be monofunctional or polyfunctional. It is preferred to use a polymer not containing an aromatic structure because the refractive index will otherwise become high.

The alkenyl monomer unit contained in the alkenyl-based polymer may be one type or two or more types.

The polymerization method for producing the alkenyl-based polymer is not particularly limited. For example, polymerization can be performed by a known method such as a solution polymerization method, a suspension polymerization method, an emulsion polymerization method, or a partial polymerization method. In the present invention, a suspension polymerization method is preferred because it is relatively easy to control the polymerization reaction and separate the resulting polymer.

An alkenyl-based polymer modified by introducing a functional group containing a double bond, such as a (meth) acryloyl group or a vinyl group, into its side chain by chemical modification may be used. As the chemical modification method, for example, a reaction between a carboxy group and a glycidyl group or a reaction between a hydroxyl group and an isocyanate group can be used.

In the case of using a reaction between a carboxy group and a glycidyl group as the chemical modification method, for example, a method of producing an alkenyl-based polymer containing an alkenyl monomer unit having a carboxy group and reacting the produced alkenyl-based polymer with a compound having a glycidyl group and a double bond, such as glycidyl (meth)acrylate, is exemplified.

For the reaction of the alkenyl-based polymer containing an alkenyl-based monomer unit having a carboxy group with the compound having a glycidyl group and a double bond, a reaction catalyst is preferably used for shortening the reaction time. Examples of the reaction catalyst include quaternary ammonium salts such as tetrabutylammonium bromide, quaternary phosphonium salts such as ethyltriphenylphosphonium bromide, and phosphine-based compounds such as triphenylphosphine. From the viewpoint that the organopolysiloxane composition of the present embodiment is less likely to be discolored, a quaternary ammonium salt is particularly preferred.

The weight average molecular weight (Mw) of the alkenyl-based polymer is preferably 5000 to 500000, and more

preferably 10000 to 200000. When the weight average molecular weight is 5000 or more, the strength of the cured product becomes favorable. When the weight average molecular weight is 500000 or less, the viscosity of the organopolysiloxane composition of the present embodiment is decreased, and thus the workability becomes favorable.

Polymerization Initiator

Examples of the polymerization initiator include a photopolymerization initiator, a thermal polymerization initiator, and a peroxide used for redox polymerization. The type of the polymerization initiator can be appropriately selected depending on the polymerization method.

Photopolymerization Initiator

The photopolymerization initiator is a radical polymerization initiator used for photopolymerization. Specific examples of the photopolymerization initiator include benzophenone-type compounds such as benzophenone, 4-methylbenzophenone, 2,4,6-trimethylbenzophenone, methyl 2-benzoylbenzoate, and 4-phenylbenzophenon; anthraquinone-type compounds such as tert-butylanthraquinone and 2-ethylanthraquinone; alkylphenone-type compounds such as 2-hydroxy-2-methyl-1-phenylpropan-1-one, oligo{2-hydroxy-2-methyl-1-[4-(1-methylvinyl)phenyl]propanone}, benzyl dimethyl ketal, 1-hydroxycyclohexylphenylketone, benzoin methyl ether, 2-methyl-[4-(methylthio)phenyl]-2-morpholino-1-propanone, and 2-hydroxy-1-{4-[4-(2-hydroxy-2-methylpropionyl)benzyl]phenyl}-2-methylpropan-1-one; thioxanthone-type compounds such as 2-benzyl-2-dimethylamino-4'-morpholinobutyrophenone, diethylthioxanthone, and isopropylthioxanthone; acylphosphine-oxide-type compounds such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; phenylglyoxylate-type compounds such as phenylglyoxilic acid methyl ester; oxime-ester-type compounds such as N-acetoxy-N-{4-acetoxyimino-4-[9-ethyl-6-(o-toluoyl)-9H-carbazol-3-yl]butan-2-yl}acetamide, N-acetoxy-N-{3-(acetoxyimino)-3-[9-ethyl-6-(1-naphthoyl)-9H-carbazol-3-yl]-1-methylpropyl}acetamide, methyl 4-acetoxyimino-5-[9-ethyl-6-(2-methylbenzoyl)-9H-carbazol-3-yl]-5-oxopentanoate, and methyl 4-acetoxyimino-5-oxo-5-(4-(phenylthio)phenyl)pentanoate, and combinations thereof.

Of these, alkylphenone-type compounds are preferred, and 2-hydroxy-2-methyl-1-phenylpropan-1-one and 1-hydroxycyclohexyl phenyl ketone are more preferred, from the viewpoint that discoloration of the cured product can be suppressed. Acylphosphine oxide-type compounds are preferred from the viewpoint of facilitating sufficient curing even in the interior of the cured product, and 2,4,6-trimethylbenzoyldiphenylphosphine oxide is more preferred from the viewpoint that discoloration of the cured product can be suppressed. Bis(2,4,6-trimethylbenzoyl)phenylphosphine oxide and methyl 4-acetoxyimino-5-oxo-5-(4-(phenylthio)phenyl)pentanoate, which have high sensitivity to light on the longer-wavelength side, are more preferred. From the viewpoint of high reactivity to light around a wavelength of 365 nm, 2-benzyl-2-dimethylamino-4'-morpholinobutyrophenone is also preferred. One type of these photopolymerization initiators may be used alone, or two or more types thereof may be used in combination.

In the case where the organopolysiloxane composition of the present embodiment (hereinafter may be referred to simply as "curable composition") is cured via photopolymerization to produce a cured product, the wavelength of light used for irradiation of the curable composition is not particularly limited, but it is preferred to irradiate the curable composition with ultraviolet light having a wavelength of 200 to 500 nm. Specific examples of the light source of ultraviolet light include an ultra-high pressure mercury lamp, a high-pressure mercury lamp, a metal halide lamp, a high-power metal halide lamp, a UV-LED lamp, a chemical lamp, and a black light. After photopolymerization of the curable composition, after-cure may be further performed. This can reduce the amount of unreacted polymerizable alkenyl groups remaining in the cured product, and can further increase the strength of the cured product. Examples of the after-cure conditions include a temperature of 50°C to 200°C for several tens of seconds to 60 minutes, or a temperature of 80°C to 150°C for several tens of seconds to 60 minutes.

Thermal Polymerization Initiator

The thermal polymerization initiator is a radical polymerization initiator used for thermal polymerization. Examples of the thermal polymerization initiator include organic peroxides and azo compounds.

Specific examples of the organic peroxides include ketone peroxides such as methyl ethyl ketone peroxide; peroxyketals such as 1,1-di(tert-hexylperoxy)-3,3,5-trimethylcyclohexane, 1,1-di(tert-hexylperoxy)cyclohexane, and 1,1-di(tert-butylperoxy)cyclohexane; hydroperoxides such as 1,1,3,3-tetramethylbutyl hydroperoxide, cumene hydroperoxide, and p-menthane hydroperoxide; dialkyl peroxides such as dicumyl peroxide and di-tert-butyl peroxide; diacyl peroxides such as dilauroyl peroxide and dibenzoyl peroxide; peroxydicarbonates such as di(4-tert-butylcyclohexyl) peroxydicarbonate and di(2-ethylhexyl) peroxydicarbonate; and peroxyesters such as tert-butyl peroxy-2-ethylhexanoate, tert-hexyl peroxyisopropyl monocarbonate, tert-butyl peroxybenzoate, and 1,1,3,3-tetramethylbutyl peroxy-2-ethylhexanoate.

Specific examples of the azo compounds include 2,2'-azobisisobutyronitrile, 2,2'-azobis(2-methylbutyronitrile), 2,2'-azobis(2,4-dimethylvaleronitrile), 1,1'-azobis-1-cyclohexanecarbonitrile, dimethyl-2,2'-azobisisobutyrate, 4,4'-azobis-4-cyanovaleric acid, and 2,2'-azobis-(2-amidinopropane) dihydrochloride.

One type of these thermal polymerization initiators may be used alone, or two or more types thereof may be used in combination. As the thermal polymerization initiator, an organic peroxide is preferred from the viewpoint that bubbles are less likely to be generated in the cured product. In consideration of the balance between the curing time and the pot life of the curable composition, the 10-hour half-life temperature of the organic peroxide is preferably 35 to 80°C, more preferably 40 to 75°C, and still more preferably 45 to 70°C. When the 10-hour half-life temperature is 35°C or higher, the curable composition is less likely to gel at normal temperature, and the pot life becomes favorable. Meanwhile, when the 10-hour half-life temperature is 80°C or lower, the curing time of the curable composition can be shortened.

Examples of such organic peroxides include 1,1,3,3-tetramethylbutyl peroxy-2-ethylhexanoate, tert-butyl peroxy-2-ethylhexanoate, and di(4-tert-butylcyclohexyl) peroxydicarbonate. Examples of commercially available products of 1,1,3,3-tetramethylbutyl peroxy-2-ethylhexanoate include PEROCTA O (trade name, available from NOF CORPORATION, 10-hour half-life temperature: 65.3°C). Examples of commercially available products of tert-butyl peroxy-2-ethylhexanoate include PERBUTYL O (trade name, available from NOF CORPORATION, 10-hour half-life temperature: 72.1°C). Examples of commercially available products of di(4-tert-butylcyclohexyl) peroxydicarbonate include PEROYL TCP (trade name, available from NOF CORPORATION, 10-hour half-life temperature: 40.8°C).

In the case where the curable composition is cured via thermal polymerization to produce a cured product, the curing conditions are not particularly limited, but the curing temperature is preferably 40 to 200°C, and more preferably 60 to 150°C, from the viewpoint that a resin for an optical member with suppressed discoloration is easily produced. The curing time (heating time) varies depending on the curing temperature, but is preferably 1 to 120 minutes, and more preferably 1 to 60 minutes.

After thermal polymerization of the curable composition, it is preferred to further perform after-cure. Examples of the after-cure conditions include a temperature of 50°C to 200°C for several tens of seconds to 60 minutes, or a temperature of 80°C to 150°C for several tens of seconds to 60 minutes.

Redox Polymerization

For the redox polymerization, a redox-based polymerization initiator is usually used. The redox-based polymerization initiator is a polymerization initiator using a peroxide and a reducing agent in combination. Examples of the peroxide used in the redox polymerization include dibenzoyl peroxide and hydroperoxide. One type of these peroxides may be used alone, or two or more types thereof may be used in combination. In the case where the above peroxide is used as a redox-based polymerization initiator, examples of a combination with a reducing agent are as follows.

(1) Combination of dibenzoyl peroxide (peroxide) and an aromatic tertiary amine (reducing agent) such as N,N-dimethylaniline, N,N-dimethyl-p-toluidine, or N,N-bis(2-hydroxypropyl)-p-toluidine.
(2) Combination of hydroperoxide (peroxide) and a metal soap (reducing agent).
(3) Combination of hydroperoxide (peroxide) and a thiourea (reducing agent).

In the case where the curable composition is cured via redox polymerization to produce a cured product, the use of the redox-based polymerization initiator enables the curable composition to be cured at a temperature of 5 to 40°C. The curing temperature is preferably 15 to 40°C from the viewpoint that the amount of unreacted (meth)acryloyl groups remaining in the resultant resin for an optical member can be reduced and that the strength of the resin for an optical member can be further increased.

A method of performing curing by a procedure of dissolving a reducing agent in the curable composition in advance and adding a peroxide thereto is preferred from the viewpoint that the curable composition is less likely to gel and can be stably handled.

When the curable composition is cured, it is preferred to cure the curable composition in a sealed state in order to suppress curing inhibition by oxygen. Examples of the sealing method include a method of sandwiching the curable composition between glass or PET films.

Chain Transfer Agent

When the curing reaction of the organopolysiloxane composition is performed in air, oxygen traps active radicals as peroxide radicals, and inhibits polymerization. However, addition of a chain transfer agent that donates hydrogen can suppress oxygen-induced polymerization inhibition.

Examples of the above chain transfer agent include thiol compounds such as mercaptocarboxylic acid esters

such as methyl mercaptoacetate, methyl 3-mercaptopropionate, 2-ethylhexyl 3-mercaptopropionate, 3-methoxybutyl 3-mercaptopropionate, n-octyl 3-mercaptopropionate, stearyl 3-mercaptopropionate, 1,4-bis(3-mercaptopropionyloxy) butane, 1,4-bis(3-mercaptobutyryloxy)butane, trimethylolethane tris(3-mercaptopropionate), trimethylolethane tris(3-mercaptobutyrate), trimethylolpropane tris(3-mercaptopropionate), trimethylolpropane tris(3-mercaptobutyrate), pentaerythritol tetrakis(3-mercaptopropionate), pentaerythritol tetrakis(3-mercaptobutyrate), dipentaerythritol hexakis(3-mercaptopropionate), dipentaerythritol hexakis(3-mercaptobutyrate), tris[2-(3-mercaptopropionyloxy)ethyl] isocyanurate, and tris[2-(3-mercaptobutyryloxy)ethyl] isocyanurate; alkylthiols such as ethanethiol, 2-methylpropane-2-thiol, n-dodecanethiol, 2,3,3,4,4,5-hexamethylhexane-2-thiol (tert-dodecanethiol), ethane-1,2-dithiol, propane-1,3-dithiol, and benzylthiol; aromatic thiols such as benzenethiol, 3-methylbenzenethiol, 4-methylbenzenethiol, naphthalene-2-thiol, pyridine-2-thiol, benzimidazole-2-thiol, and benzothiazole-2-thiol; mercaptoalcohols such as 2-mercaptoethanol and 4-mercapto-1-butanol; and silane-containing thiols such as 3-(trimethoxysilyl)propane-1-thiol and 3-(triethoxysilyl)propane-1-thiol. Of these, a secondary thiol compound is preferably used from the viewpoint of the reactivity and storage stability of the curable composition.

When the chain transfer agent is added, one type of the chain transfer agents may be used alone, or two or more types thereof may be used in combination. The amount of the chain transfer agent added is preferably 0.01 to 20 parts by mass, more preferably 0.1 to 10 parts by mass, and still more preferably 0.5 to 10 parts by mass, relative to 100 parts by mass of the total amount of the polymerizable components. When a mixture of two or more types is used, the total amount of the chain transfer agents should be within the above range.

Solvent

A solvent may be contained for the purpose of diluting the organopolysiloxane and the composition thereof. The type of the solvent is not particularly limited as long as the physical properties required for the organopolysiloxane and the cured product of the composition thereof are not impaired. Examples of the solvent that may be used include aromatic hydrocarbons having good solubility (e.g., toluene, xylene, ethyl benzoate, ethylbenzene, and benzyl alcohol), ketones (e.g., acetone, methyl ethyl ketone, methyl isobutyl ketone, diisobutyl ketone, cyclohexanone, and diacetone alcohol), esters (e.g., methyl acetate, ethyl acetate, butyl acetate, sec-butyl acetate, methoxybutyl acetate, amyl acetate, normal propyl acetate, ethyl lactate, methyl lactate, butyl lactate, propylene glycol monomethyl ether acetate, and γ-butyrolactone), ethers (e.g., isopropyl ether, ethylene glycol monomethyl ether, propylene glycol monomethyl ether, ethylene glycol monobutyl ether, 1,4-dioxane, methyl-tert-butyl ether, and tetrahydrofuran), alcohols (e.g., methanol, ethanol, normal propanol, isopropanol, butanol, sec-butanol, tert-butanol, and normal pentanol), halogen-based solvents (e.g., methylene chloride, trichloroethylene, tetrachloroethylene, bromopropane, and chloroform), and others (e.g., dimethyl sulfoxide, N,N-dimethylformamide, and water). Two or more types of solvents may be used.

The solvent content is not particularly limited as long as physical properties required for the organopolysiloxane and the cured product of the composition thereof are not impaired. However, when it is desired to reduce the viscosity while suppressing the volatile content to a small amount, the content is preferably more than 0 mass% and 25 mass% or less relative to the entire organopolysiloxane or the entire composition thereof. When it is desired to produce a cured product as a thin film, the content is preferably 75 mass% or more and less than 100 mass% relative to the entire organopolysiloxane or the entire composition thereof.

Antioxidant

The curable composition preferably further contains an antioxidant. The incorporation of an antioxidant in the curable composition can suppress discoloration due to heat, such as heating during soldering of a cured product or heat generated by a device.

Specific examples of the antioxidant include phenol-based antioxidants such as 2,6-di-tert-butylphenol, 2,6-di-tert-butyl-p-cresol, n-octadecyl-3-(3',5'-di-tert-butyl-4'-hydroxyphenyl)propionate, tetrakis-[methylene-3-(3',5'-di-tert-butyl-4'-hydroxyphenyl)propionate]methane, triethylene glycol bis[3-(3-tert-butyl-5-methyl-4-hydroxyphenyl)propionate], and 1,6-hexanediol bis[3-(3,5-di-tert-butyl-4-hydroxyphenyl)propionate]; phosphorus-based antioxidants such as triphenyl phosphite, trisisodecyl phosphite, tristridecyl phosphite, tris(2,4-di-tert-butylphenyl) phosphite, tetra(C12-C15 alkyl)-4,4'-isopropylidenediphenyl diphosphite; and sulfur-based antioxidants such as dilauryl-3,3'-thiodipropionate, ditridecyl-3,3'-thiodipropionate, dimyristyl-3,3'-thiodipropionate, distearyl-3,3'-thiodipropionate, and pentaerythritol tetrakis(β-laurylthiopropionate). One type of these antioxidants may be used alone or two or more types thereof may be used in combination.

Additional Component

The curable composition of the present embodiment may contain an additional component such as a filler, a

curing control agent, and a viscosity modifier. These components can be appropriately contained to the extent that they do not affect the transmission loss, heat resistance, and refractive index of the cured product of the organopolysiloxane composition according to the present embodiment.

Curing of Organopolysiloxane Composition

Another embodiment of the present invention is a cured product produced by curing the above-described organopolysiloxane composition (curable composition) with heat or light.

The curing conditions for the organopolysiloxane composition are not particularly limited, and the organopolysiloxane composition can be cured under conditions that are appropriately employed for curing silicone resins, depending on the type of polymerization initiator and the like.

Properties of Cured Product

When the organopolysiloxane of the present first aspect, having a polymerizable alkenyl group and a unit containing a Q unit ($SiO_{4/2}$), and a composition thereof are cured as described above, a cured product having the following properties can be produced.

• Heat Resistance

A cured product having a 1% weight loss temperature of preferably 285°C or higher, more preferably 290°C or higher, and having high reflow resistance can be produced. The measurement of the weight loss temperature is in accordance with the method described in the Examples below.

• Transmission Loss

A cured product suitable for a core material of an optical waveguide having a transmission loss of preferably 0.30 dB/cm or less, more preferably 0.25 dB/cm or less, at near-infrared wavelengths can be produced. The measurement of the transmission loss is in accordance with the method described in the Examples below.

When the organopolysiloxane of the present second aspect, having an organic group containing a polymerizable alkenyl group and not having an aromatic structure, and a composition thereof are cured as described above, a cured product having the following properties can be produced.

• Heat Resistance

A cured product having a 5% weight loss temperature of preferably 330°C or higher, more preferably 333°C or higher, and having high reflow resistance can be produced. The measurement of the weight loss temperature is in accordance with the method described in the Examples below.

The organopolysiloxane composition of the present embodiment is particularly suitable for near-infrared optical waveguide applications. Therefore, in another embodiment of the present invention, an organopolysiloxane composition for a near-infrared optical waveguide is also provided. Each of the aspects, requirements, and the like of the organopolysiloxane composition for a near-infrared optical waveguide is as described above for the organopolysiloxane composition.

Hereinafter, the term "organopolysiloxane composition" shall mean both the organopolysiloxane composition and the organopolysiloxane composition for a near-infrared optical waveguide.

Near-Infrared Optical Waveguide and Near-Infrared Optical Transmission Member

A near-infrared optical waveguide produced using the above organopolysiloxane composition and a near-infrared optical transmission member including at least the near-infrared optical waveguide are also within the scope of the present invention.

As described below, a near-infrared optical waveguide including a cured product produced by curing the above organopolysiloxane composition and a near-infrared optical transmission member including at least the near-infrared optical waveguide are also within the scope of the present invention.

Furthermore, as described below, a method for producing a near-infrared optical waveguide using the above organopolysiloxane composition is also within the scope of the present invention.

The near-infrared optical waveguide of the present invention includes at least a core and/or a cladding formed by curing the organopolysiloxane composition, and may include a base material (also referred to as a "substrate").

The near-infrared optical waveguide of the present invention preferably includes a core and a cladding produced using the organopolysiloxane composition.

The cladding may be composed of a lower cladding and an upper cladding.

The near-infrared optical transmission member of the present invention may include, in addition to the near-infrared optical waveguide, an optical fiber such as a mirror or a connector, a connection member with a silicon photonics optical circuit, or the like.

The above organopolysiloxane composition is applicable to both a cladding-forming material for forming a cladding of an optical waveguide and a core-forming material for forming a core of an optical waveguide, but the refractive index of the core material for forming a core is required to be higher than that of the cladding material forming a cladding.

The refractive index of the cured product can be controlled by changing the proportions of the constituent units of the organopolysiloxane. For example, by increasing the value of M2 + D2 + T2 in Formula [1] above in the present first aspect or Formula [21] above in the present second aspect, i.e., by increasing the content proportion of the polymerizable alkenyl group, the density of the cured product to be produced can be increased, resulting in an increase in refractive index. On the contrary, by reducing the value of M2 + D2 + T2, i.e., by reducing the content proportion of the polymerizable alkenyl group, the density of the cured product to be produced can be reduced, resulting in a decrease in refractive index. The refractive index of the cured product can also be controlled by changing the component proportion of the organopolysiloxane composition or by other methods.

Further, by adjusting the content (vol%) of the polymerizable alkenyl group of the polymerizable alkenyl compound and/or the alkenyl-based polymer contained in the organopolysiloxane composition, the crosslinking density of the cured product can be controlled in the same manner as described above, and thus the refractive index can be controlled. Besides, in the organopolysiloxane of the present first aspect, the refractive index can be increased by increasing the aromatic group content (vol%) of the cured product, and the refractive index can be reduced by increasing the fluorine content (vol%). Moreover, the refractive index of the cured product can be controlled by combining these methods.

In the case of a near-infrared single-mode optical signal, the difference in refractive index between a core material and a cladding material is preferably 0.01 to 0.05, more preferably 0.01 to 0.04, still more preferably 0.01 to 0.03, and yet still more preferably 0.01 to 0.02.

When a near-infrared optical waveguide is connected to a near-infrared single-mode quartz-based optical fiber in equipment, a smaller difference in refractive index between the core material of the quartz-based optical fiber and the core material of the optical waveguide leads to less interface reflection of light at the connection portion, which can result in smaller connection loss. In general, the refractive index of the core material of a near-infrared single-mode quartz-based optical fiber at near-infrared wavelengths is 1.4 to 1.5. When the refractive index of the core material of the optical waveguide is 1.400 to 1.500 at a wavelength of 589 nm and 1.400 to 1.500 at a wavelength of 1300 nm, more preferably 1.430 to 1.490 at a wavelength of 589 nm and 1.420 to 1.480 at a wavelength of 1300 nm, and still more preferably 1.435 to 1.480 at a wavelength of 589 nm and 1.425 to 1.470 at a wavelength of 1300 nm, the difference in refractive index between the two materials becomes smaller, and the connection loss can become even smaller.

The method for producing the near-infrared optical waveguide to which the present invention is directed is not particularly limited. For example, the optical waveguide can be formed through a step of curing the above organopolysiloxane composition by exposure (photocuring) or by heating (thermal curing). As a typical example, the optical waveguide can be formed through an etching step and a development step by using a lithography technique with a photomask. When the optical waveguide is produced by photolithography, it is preferred to use an organopolysiloxane composition containing at least an organopolysiloxane and a photopolymerization initiator, and an organopolysiloxane composition to which a solvent, a chain transfer agent, and the like are further added as necessary can be used. Alternatively, a method such as nanoimprinting can be used to produce the optical waveguide.

The optical waveguide formation method by the above photolithography method is particularly preferred because an optical waveguide having a small line width and a small pitch can be produced.

As the base material of the near-infrared optical waveguide, a silicon wafer, a silicon wafer with an oxide film, a polyimide resin, an epoxy resin, a PEEK resin, a liquid crystal polymer, glass, a glass epoxy substrate, or the like can be used. When the photolithography technique is used, the core of the optical waveguide can be formed on the base material through steps of applying the organopolysiloxane composition onto the base material, exposing the composition to light through a photomask, and washing the unexposed portion with a solvent. Further, an overcladding can be formed by applying the organopolysiloxane composition onto the core formed on the base material and then curing the composition. Before formation of the core on the base material, an undercladding may be formed in advance by applying the organopolysiloxane composition onto the base material and curing the composition. After formation of the core and the cladding of the optical waveguide on the base material, the waveguide may be peeled off from the base material.

In another embodiment, the present invention provides the following method for producing a near-infrared optical waveguide (also referred to as the present production method).

A first aspect of the present production method is required to include:

(i-1) applying a first curable polymer composition to a surface of a substrate to form a first polymer layer;
(i-2) irradiating at least one selected region of the first polymer layer with an active energy ray having a wavelength of 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane composition or the organopolysiloxane composition for a near-infrared optical waveguide according to the present invention.

In the above first aspect, it is preferred to further include:

(i-4) coating the surface of the substrate and the core with a second curable polymer composition to form a second polymer layer; and
(i-5) curing the second polymer layer to form an upper cladding.

The second curable polymer composition is not particularly limited as long as it is a curable composition, but is preferably the organopolysiloxane composition of the present invention.

A second aspect of the present production method is required to include:

(ii-1) applying a third curable polymer composition to a surface of a substrate to form a third polymer layer;
(ii-2) irradiating at least one selected region of the third polymer layer with an active energy ray having a wavelength of 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer or the fourth curable polymer composition is the above organopolysiloxane composition.

As described above, as long as at least one of the third curable polymer composition or the fourth curable polymer composition is the above organopolysiloxane composition, the other curable polymer composition is not particularly limited as long as it is a curable composition. In this aspect, both of the third curable polymer and the fourth curable polymer composition are preferably the above organopolysiloxane composition.

A third aspect of the present production method is required to include:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the above organopolysiloxane composition.

As described above, as long as at least one of the fifth curable polymer composition or the sixth curable polymer composition is the above organopolysiloxane composition, the other curable polymer composition is not particularly limited as long as it is a curable composition. In this aspect, both of the fifth curable polymer composition and the sixth curable polymer composition are preferably the above organopolysiloxane composition.

A fourth aspect of the present production method is required to include:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of 150 to 800 nm to produce a partially exposed layer having at least one exposed region and at least one unexposed

region;

(iv-5) removing the unexposed region of the partially exposed layer with a solvent to form a patterned core;

(iv-6) coating the lower cladding and the core with a seventh curable polymer composition to form a seventh polymer layer; and

(iv-7) curing the seventh polymer layer to form an upper cladding, in this order, wherein

at least one of the fifth curable polymer composition, the sixth curable polymer composition, or the seventh curable polymer composition is the above organopolysiloxane composition.

In this aspect, all of the fifth curable polymer composition, the sixth curable polymer composition, and the seventh curable polymer composition are preferably the organopolysiloxane composition for a near-infrared optical waveguide according to the present invention.

As the substrate, the above base material can be used. The surface of the substrate to be used is preferably subjected to ozone treatment, plasma treatment, corona treatment, or the like in advance in order to remove deposits on the surface, prevent repelling of the curable polymer composition to be applied, or improve the adhesion. Similarly, before the formation of the core and the formation of the upper cladding, the surfaces on which the core and the upper cladding are to be formed are preferably subjected to ozone treatment, plasma treatment, corona treatment, or the like in advance.

In regard to the first to seventh curable polymer compositions, as described above, at least a portion thereof in each aspect is required to be the above organopolysiloxane composition, but any other curable polymer composition may be any other polymer composition that forms the core, the lower cladding, or the upper cladding.

Examples of any other polymer composition include, but are not limited to, curable silicone compositions other than the above organopolysiloxane composition; curable polyolefin compositions; curable polyamide compositions; curable epoxy resin compositions; curable amino resin compositions; curable polyurethane compositions; curable polyimide compositions; curable polyester compositions; and curable acrylic resin compositions.

The curable polymer composition can be applied to a substrate by any common method such as spin coating, die coating, gravure coating, dipping, spraying, brushing, or screen printing. Typically, the curable polymer composition can be applied by spin coating. The spin speed and spin time, as well as the solid content, viscosity, and the like of the curable polymer composition can be controlled so as to provide a polymer layer having a desired thickness.

When the curable polymer composition contains a solvent, the present production method may further include a step of removing at least a portion of the solvent from the formed polymer layer. The solvent can be removed by heating the polymer layer at a temperature of 50°C to 200°C for several tens of seconds to 60 minutes, or alternatively at a temperature of 80°C to 150°C for several tens of seconds to 60 minutes. Alternatively, the solvent may be removed under reduced pressure, or the solvent may be removed under reduced pressure and then further removed by heating.

The polymer layer can be cured by various means depending on the curing mechanism of the curable polymer composition. Examples of the means include heating, exposure (active energy rays such as radiation irradiation and ultraviolet irradiation), and steam. Each condition can be selected as appropriate. For example, an exposure device with a high-pressure mercury lamp light source can be used for the curing. The atmosphere during exposure may be air or an inert atmosphere. When the exposure is performed under an inert atmosphere, an uncured layer formed on the surface of the polymer layer can be reduced.

However, in the polymer layer forming the core, at least one selected region is irradiated with an active energy ray having a wavelength of 150 to 800 nm to produce a partially exposed layer having at least one exposed region and at least one unexposed region. Also in the polymer layer forming the cladding, at least one selected region may be irradiated with an active energy ray having a wavelength of 150 to 800 nm to produce a partially exposed layer having at least one exposed region and at least one unexposed region.

After the polymer layer is cured, the cured layer may be further heated and may be exposed again. These treatments may promote curing, and improve the adhesion between the polymer layer and the substrate, or the adhesion between the polymer layers. Examples of the conditions of the above heat treatment include a temperature of 50°C to 200°C for several tens of seconds to 60 minutes, or a temperature of 80°C to 150°C for several tens of seconds to 60 minutes.

In the step of forming the core, after the curable polymer composition is cured, a so-called development treatment of removing the unexposed region with a solvent is performed in order to remove the unexposed region. The solvent used for the development and the development method are not limited, and the solvent may be any solvent as long as the curable polymer composition is dissolved therein, and the curable polymer composition in the unexposed portion is dissolved by any method such as dipping or spraying. Also in the step of forming the cladding, after the curable polymer composition is cured, a so-called development treatment of removing the unexposed region with a solvent may be performed in order to remove the unexposed region. The solvent used for the development and the development method are not limited, and the solvent may be any solvent as long as the curable polymer composition is dissolved therein, and the curable polymer composition in the unexposed portion is dissolved by any method such as dipping or spraying. In the step of forming the core and the upper and lower claddings, the same step as the above development may be used in order to

remove the uncured layer on the surface of the polymer layer. After the unexposed region is removed with the solvent, the solvent is preferably removed by air drying or heating.

In general, the lower and the upper claddings have a thickness of about 1 to 100 μm, and the core has a thickness of 1 to 50 μm. The refractive index of the core is preferably higher than that of the cladding. Depending on the size and refractive index of the core, light can be transmitted in a desired propagation mode.

The present production method can be extended to a high-throughput production method. Multiple optical waveguides can also be produced simultaneously on a single substrate. Furthermore, the method can use traditional wafer production techniques (e.g., coating, exposing, developing, and curing) and equipment.

The optical waveguide produced according to the present production method has a superior microfabrication property, heat resistance, and low transmission loss at near-infrared wavelengths, and can reduce the connection loss due to reflection at the interface between the optical fiber and the optical waveguide, as compared to optical waveguides containing other known materials.

## Examples

The present invention will be further described below by way of Examples, but the present invention is not limited by the Examples.

### Evaluation Method

#### (1) $^{1}$H-NMR Measurement Method

The organopolysiloxane to be measured was weighed in an amount of 60 mg, and 12 mg of N,N-dimethylformamide was added thereto as an internal standard. Further, deuterated chloroform was added to dissolve the mixture in 1 g, and the solution was placed in an NMR sample tube and measured by 400 MHz $^{1}$H-NMR (AVANCE NEO 400, BBFO Probe (5 mm diameter), available from Bruker Corporation) under the following conditions: pulse repetition time/5 seconds, number of scans/16 times, measuring mode/single pulse, measurement temperature/25°C, flip angle/30°, spin/20 Hz, measurement temperature 25°C. The functional group content was estimated from the ratio of the signal intensity of each component to the signal intensity of N,N-dimethylformamide as an internal standard, and the weighed value.

#### (2) $^{29}$Si-NMR Measurement Method

- Device: JNM-ECS400 available from JEOL Ltd., TUNABLE Probe (10 mm diameter): Si-free, AT10 probe
- Measurement Conditions: pulse repetition time/16 seconds, number of scans/1024 times, measurement mode/non-gated decoupled pulse method (NNE), flip angle/90°, spin/off, measurement temperature/25°C
- Preparation of Samples: Tris(2,4-pentanedionato)chromium(III) was added to deuterated chloroform so as to be 0.5 mass%, to thereby prepare a solvent for $^{29}$Si-NMR measurement. The organopolysiloxane to be measured was weighed in an amount of 1.5 g, dissolved in 2.5 ml of the above solvent for $^{29}$Si-NMR measurement, and the resultant solution was placed into an NMR sample tube.
- Calculation of Constituent Unit: The signal intensity of each unit of silicon was measured, and the constituent proportion of the silicon unit was calculated from the ratio to the signal intensity measured by the above $^{1}$H-NMR and the ratio to the functional group content.

#### (3) Measurement of Refractive Index of Cured Product

Using a Kalnew precision refractometer KPR2000 available from Shimadzu Corporation, the refractive index of a cured product at a wavelength of 589 nm was measured at a temperature of 23°C using a mixture of diiodomethane, monobromonaphthalene, and liquid paraffin as an intermediate liquid.

Alternatively, using a prism coupler Model 2010/M available from Metricon Corporation, the refractive indices of a cured thin film product formed on a substrate at wavelengths of 1300 nm and 1550 nm were measured.

#### (4) Thermal Weight Loss Temperature

Using a thermogravimetric measurement apparatus STA200 available from Hitachi High-Tech Corporation, the measurement was performed under air and a temperature rise condition of 10°C/min.

(5) Transmission Loss

Using a spectrophotometer U-4000 available from Hitachi High-Tech Corporation, the transmittances of cured products having a thickness of about 0.5 mm and a thickness of about 1 mm at a wavelength of 1310 nm were measured, and the transmission loss L (dB/cm) was calculated using Equation [6].

$$L = -(10/\Delta d) \times \log_{10}(T_{1.0}/T_{0.5}) \quad [6]$$

$\Delta d$ (cm): Difference in film thickness between two samples
$T_{1.0}$ (%): Transmittance of a sample having a film thickness of about 1.0 mm
$T_{0.5}$ (%): Transmittance of a sample having a film thickness of about 0.5 mm

Method for Synthesizing Organopolysiloxane

Synthesis Example 1 Synthesis Method for Organopolysiloxanes A to E

The organopolysiloxane raw materials used were 1.600 g of Methyl Silicate MS51 available from Mitsubishi Chemical Corporation, 40.00 g of 3-methacryloyloxypropyltrimethoxysilane KBM503 available from Shin-Etsu Chemical Co., Ltd., and 17.92 g of hexamethyldisiloxane available from NACALAI TESQUE, INC., the solvents used were 23.04 g of toluene and 23.04 g of methanol, and the catalysts and water used were a mixture of 10.62 g of 1N hydrochloric acid and 10.62 g of methanol. The mixture of the above materials was subjected to hydrolytic condensation while maintaining the temperature at 15°C to 40°C. Thereafter, the reaction liquid was neutralized and washed with demineralized water. Then, the solvent and water were removed and filtered to produce 34 g of liquid organopolysiloxane A of interest.
The amounts of organopolysiloxane raw materials were changed as appropriate and synthesized in the same manner to produce organopolysiloxanes B to E.

Synthesis Example 2 Synthesis Method for Organopolysiloxane F

Organopolysiloxane F was produced in the same manner as in Synthesis Example 1 except that p-styryltrimethoxysilane KBM1403 available from Shin-Etsu Chemical Co., Ltd. was used as the organopolysiloxane raw material instead of 3-methacryloyloxypropyltrimethoxysilane KBM503 available from Shin-Etsu Chemical Co., Ltd.

Synthesis Example 3 Synthesis Method for Organopolysiloxane H

Organopolysiloxane H was produced in the same manner as in Synthesis Example 1 except that 3-methacryloyloxypropyltrimethoxysilane KBM503 available from Shin-Etsu Chemical Co., Ltd. and dimethoxydimethylsilane available from Tokyo Chemical Industry Co., Ltd. were used as the organopolysiloxane raw materials.

Synthesis Example 4 Synthesis Method for Organopolysiloxane G

With reference to JP 2014-510159 A, organopolysiloxane G was produced by using 3-methacryloyloxypropyltrimethoxysilane KBM503 available from Shin-Etsu Chemical Co., Ltd. and diphenylsilanediol available from Tokyo Chemical Industry Co., Ltd. as the organopolysiloxane raw materials.

Method for Producing Cured Product

To each of 100 parts by mass of liquid organopolysiloxanes A to H produced in Synthesis Examples 1 to 4, 2.0 parts by mass of 2-benzyl-2-(dimethylamino)-4'-morpholinobutyrophenone (Omnirad 369) available from IGM Resins B.V. was added as a photopolymerization initiator, and to 100 parts by mass of organopolysiloxane G, 0.5 parts by mass of Omnirad 369 was added as a photopolymerization initiator. Each mixture was stirred to dissolve the photopolymerization initiator, to thereby prepare a composition.
Furthermore, a composition was also prepared by adding 2.0 parts by mass of 2-benzyl-2-(dimethylamino)-4'-morpholinobutyrophenone (Omnirad 369) available from IGM Resins B.V. as a photopolymerization initiator and 10 parts by mass of pentaerythritol tetrakis(3-mercaptobutyrate) (PE1, available from Resonac Corporation) as a chain transfer agent to 100 parts by mass of organopolysiloxane B.
In addition, a composition was also prepared by adding 2.0 parts by mass of 2,4,6-trimethylbenzoyldiphenylphosphine oxide (Omnirad TPO H, available from IGM Resins B.V.) instead of Omnirad 369 as a photopolymerization initiator

to 100 parts by mass of organopolysiloxane C, and a composition was also prepared by using 2 parts by mass of bis(2,4,6-trimethylbenzoyl)-phenylphosphine oxide (Omnirad 819, available from IGM Resins B.V.) instead of Omnirad 369 as a photopolymerization initiator to 100 parts by mass of organopolysiloxane C.

Each of these compositions was sandwiched between two sheets of glass via a silicone spacer having a thickness of 1 mm, and exposed to light from an LED having a wavelength of 365 nm (integrated light quantity: 6000 $mJ/cm^2$) to prepare a test piece having a thickness of about 1 mm. For the composition for evaluating the transmission loss, it was sandwiched between two sheets of glass via a silicone spacer having a thickness of 0.5 mm, and exposed to light from an LED having a wavelength of 365 nm (integrated light quantity: 6000 $mJ/cm^2$) to prepare a test piece having a thickness of about 0.5 mm as well.

Method for Producing Cured Thin Film Product on Substrate

To 100 parts by mass of each of organopolysiloxanes A to H, 2.0 parts by mass of 2-benzyl-2-(dimethylamino)-4'-morpholinobutyrophenone (Omnirad 369, available from IGM Resins B.V.) as a photopolymerization initiator and 60 parts by mass of propylene glycol monomethyl ether acetate as an organic solvent were added. Each mixture was stirred at room temperature to prepare a composition.

As the composition containing organopolysiloxane B above, a composition was prepared by further adding 10 parts by mass of pentaerythritol tetrakis(3-mercaptobutyrate) (PE1, available from Resonac Corporation) as a chain transfer agent.

As the composition containing organopolysiloxane C above, a composition to which 2.0 parts by mass of Omnirad TPO H was added instead of Omnirad 369 as a photopolymerization initiator, a composition to which 2.0 parts by mass of Omnirad 819 was added instead of Omnirad 369, and a composition to which 2.0 parts by mass of methyl 4-acetoxyimino-5-oxo-5-(4-(phenylthio)phenyl)pentanoate (photopolymerization initiator-1) was added instead of Omnirad 369 were also prepared.

After each of these compositions was applied onto a glass substrate by spin coating, the solvent was removed by reduced pressure treatment. Thereafter, it was exposed to light from an LED at a wavelength of 365 nm (integrated light quantity: 1000 $mJ/cm^2$) to produce a cured thin film product on the substrate.

Examples 1 to 6, Comparative Examples 1 to 3, and Reference Examples 1 to 3

Molecular Constituent Proportion of Liquid Organopolysiloxane and Physical Properties of Cured Product

As Examples 1 to 6, a cured product and a cured thin film product on a glass substrate were produced by the method as described above using each of liquid organopolysiloxanes C to E. As Comparative Examples 1 to 3, a cured product and a cured thin film product on a glass substrate were produced by the method as described above using liquid organopolysiloxane G, H, or F. As Reference Examples 1 to 3, a cured product and a cured thin film product on a glass substrate were produced by the method as described above using liquid organopolysiloxane A or B.

For each of them, the molecular constituent proportion of the liquid organopolysiloxane before curing and the physical properties of the cured product calculated by $^1$H-NMR and $^{29}$Si-NMR measurements are shown in Table 1, Table 2-1, and Table 2-2.

[Table 1]

Table 1

| | Type of organopolysiloxane | Aromatic structure of organopolysiloxane | Photopolymerization initiator | Coefficients in Formula [1] and Formula [21] | | | | | | | | | Refractive index of cured product | | | 1% Weight loss temperature of cured product (°C) | 5% Weight loss temperature of cured product (°C) |
|---|---|---|---|---|---|---|---|---|---|---|---|---|---|---|---|---|---|
| | | | | M1 | M2 | D1 | D2<br>T1 | | T2 | Q | Y1 | Y2 | 589 nm | 1300 nm | 1550 nm | | |
| Example 1 | C | Absent | Omnirad 369 | 0.384 | 0 | 0 | 0 | 0 | 0.209 | 0.407 | 0.096 | 0 | 1.452 | 1.439 | 1.437 | 304 | 360 |
| Example 2 | D | Absent | Omnirad 369 | 0.434 | 0 | 0 | 0 | 0 | 0.179 | 0.387 | 0.079 | 0 | 1.448 | 1.438 | 1.436 | 294 | 348 |
| Example 3 | E | Absent | Omnirad 369 | 0.479 | 0 | 0 | 0 | 0 | 0.119 | 0.402 | 0.070 | 0 | 1.437 | 1.429 | 1.426 | 285 | 334 |
| Example 4 | C | Absent | Omnirad TPO H | 0.384 | 0 | 0 | 0 | 0 | 0.209 | 0.407 | 0.096 | 0 | - | 1.440 | 1.438 | 284 | 354 |
| Example 5 | C | Absent | Omnirad 819 | 0.384 | 0 | 0 | 0 | 0 | 0.209 | 0.407 | 0.096 | 0 | - | 1.439 | 1.437 | 286 | 347 |
| Example 6 | C | Absent | Photopolymerization Initiator-1 | 0.384 | 0 | 0 | 0 | 0 | 0.209 | 0.407 | 0.096 | 0 | - | 1.453 | 1.452 | - | - |
| Comparative Example 1 | G | Present | Omnirad 369 | 0 | 0 | 0.530 | 0 | 0 | 0.470 | 0 | 0.487 | 0 | 1.558 | 1.538 | - | 227 | 352 |
| Comparative Example 2 | H | Absent | Omnirad 369 | 0 | 0 | 0.501 | 0 | 0 | 0.499 | 0 | 0.134 | 0 | 1.476 | 1.463 | 1.461 | 281 | 359 |
| Comparative Example 3 | F | Present | Omnirad 369 | 0.413 | 0 | 0 | 0 | 0 | 0.269 | 0.318 | 0.087 | 0 | 1.491 | - | - | 367 | 448 |

[Table 2-1]

Table 2-1

| | Type of organopolysiloxane | Aromatic structure of organopolysiloxane | Photopolymerization initiator | Additional additive*1 | Coefficients in Formula [1] and Formula [21] | | | | | | | | |
|---|---|---|---|---|---|---|---|---|---|---|---|---|---|
| | | | | | M1 | M2 | D1 | D2 | T1 | T2 | Q | Y1 | Y2 |
| Reference Example 1 | A | Absent | Omnirad 369 | - | 0.361 | 0 | 0 | 0 | 0 | 0.591 | 0.048 | 0.096 | 0 |
| Reference Example 2 | B | Absent | | - | 0.388 | 0 | 0 | 0 | 0 | 0.309 | 0.303 | 0.131 | 0 |
| Reference Example 3 | B | Absent | | PE1 | 0.388 | 0 | 0 | 0 | 0 | 0.309 | 0.303 | 0.131 | 0 |

*1: Additional additive is an additive other than the photopolymerization initiator and the solvent

[Table 2-2]

Table 2-2

| | Refractive index of cured product | | | 1% Weight loss temperature of cured product (°C) | 5% Weight loss temperature of cured product (°C) | Transmission loss of cured product (dB/cm) |
|---|---|---|---|---|---|---|
| | 589 nm | 1300 nm | 1550 nm | | | |
| Reference Example 1 | 1.475 | 1.469 | 1.467 | 293 | 358 | - |
| Reference Example 2 | 1.462 | 1.453 | 1.452 | 306 | 356 | 0.25 |
| Reference Example 3 | - | 1.456 | 1.454 | 301 | 352 | - |

Hereinafter, optical waveguides were produced using the organopolysiloxanes for a near-infrared optical waveguide.

Example 7

Production Method 1 for Optical Waveguide Having Core on Substrate

To 100 parts by mass of organopolysiloxane B above, 2.0 parts by mass of 2-benzyl-2-(dimethylamino)-4'-morpholinobutyrophenone (Omnirad 369, available from IGM Resins B.V.) as a photopolymerization initiator, 10 parts by mass of pentaerythritol tetrakis(3-mercaptobutyrate) (PE1, available from Resonac Corporation) as a chain transfer agent, and 20 parts by mass of propylene glycol monomethyl ether acetate as an organic solvent were added. The mixture was stirred at room temperature. This composition was designated as a first curable polymer composition. The first curable polymer composition was applied by spin coating onto a silicon wafer substrate whose surface had been treated with ozone. Thereafter, the solvent was removed by reduced pressure treatment, followed by mask exposure with an exposure device (intensity at a wavelength of 365 nm: 500 mW/cm$^2$, integrated light quantity: 2000 mJ/cm$^2$). After heating at 130°C for 10 minutes, the composition in the unexposed portion was washed away using propylene glycol monomethyl ether acetate and subsequently using 2-propanol. Then, heating was performed in a heating furnace at 130°C for 30 seconds, followed by further heating in a heating furnace at 150°C for 1 hour, to thereby produce a core of an optical waveguide on the silicon wafer substrate.

FIG. 1 is a schematic cross-sectional view of the optical waveguide produced in Example 7.

Example 8

Production Method 2 for Optical Waveguide Having Core/Upper Cladding on Substrate

To 100 parts by mass of organopolysiloxane C above, 2.0 parts by mass of 2-benzyl-2-(dimethylamino)-4'-morpholinobutyrophenone (Omnirad 369, available from IGM Resins B.V.) as a photopolymerization initiator and 20 parts by mass of propylene glycol monomethyl ether acetate as an organic solvent were added. The mixture was stirred at room temperature. This composition was designated as a second curable polymer composition. The silicon wafer substrate surface on which the core of the optical waveguide was produced as obtained in Example 7 was subjected to plasma treatment, and the second curable polymer composition was applied by spin coating. Thereafter, the solvent was removed by reduced pressure treatment, followed by exposure with an exposure device (intensity at a wavelength of 365 nm: 40 mW/cm$^2$, integrated light quantity: 1000 mJ/cm$^2$). After heating at 130°C for 10 minutes, the insufficiently cured portion of the coating film surface was washed away using propylene glycol monomethyl ether acetate and subsequently using 2-propanol. Heating was performed in a heating furnace at 130°C for 30 seconds, followed by further heating in a heating furnace at 150°C for 1 hour, to thereby produce an optical waveguide having the core and an upper cladding on the silicon wafer substrate.

FIG. 2 is a schematic cross-sectional view of the optical waveguide produced in Example 8.

Example 9

Production Method 3 for Optical Waveguide Having Lower Cladding/Core on Substrate

To 100 parts by mass of organopolysiloxane C above, 2.0 parts by mass of 2-benzyl-2-(dimethylamino)-4'-morpholinobutyrophenone (Omnirad 369, available from IGM Resins B.V.) as a photopolymerization initiator and 20 parts by mass of propylene glycol monomethyl ether acetate as an organic solvent were added. The mixture was stirred at room temperature. This composition was designated as a fifth curable polymer composition. The fifth curable polymer composition was applied by spin coating onto a silicon wafer substrate whose surface had been treated with ozone. Thereafter, the solvent was removed by reduced pressure treatment, followed by exposure with an exposure device (intensity at a wavelength of 365 nm: 40 $mW/cm^2$, integrated light quantity: 1000 $mJ/cm^2$). After heating at 130°C for 10 minutes, the insufficiently cured portion of the coating film surface was washed away using propylene glycol monomethyl ether acetate and subsequently using 2-propanol. Then, heating was performed in a heating furnace at 130°C for 30 seconds, to thereby produce a lower cladding formed of the fifth curable polymer composition on the silicon wafer substrate.

To 100 parts by mass of organopolysiloxane B above, 2.0 parts by mass of 2-benzyl-2-(dimethylamino)-4'-morpholinobutyrophenone (Omnirad 369, available from IGM Resins B.V.) as a photopolymerization initiator, 10 parts by mass of pentaerythritol tetrakis(3-mercaptobutyrate) (PE1, available from Resonac Corporation) as a chain transfer agent, and 20 parts by mass of propylene glycol monomethyl ether acetate as an organic solvent were added. The mixture was stirred at room temperature. This composition was designated as a sixth curable polymer composition. The silicon wafer substrate surface on which the lower cladding was produced as described above was subjected to plasma treatment, and the sixth curable polymer composition was applied by spin coating. Thereafter, the solvent was removed by reduced pressure treatment, followed by mask exposure with an exposure device (intensity at a wavelength of 365 nm: 500 $mW/cm^2$, integrated light quantity: 2000 $mJ/cm^2$). After heating at 130°C for 10 minutes, the composition of the unexposed portion was washed away using propylene glycol monomethyl ether acetate and subsequently using 2-propanol. Then, heating was performed in a heating furnace at 130°C for 30 seconds, followed by further heating in a heating furnace at 150°C for 1 hour, to thereby produce an optical waveguide having the lower cladding formed of the fifth curable polymer composition and a core formed of the sixth curable polymer composition on the silicon wafer substrate.

FIG. 3 is a schematic cross-sectional view of the optical waveguide produced in Example 9.

Example 10

Production Method 4 for Optical Waveguide Having Lower Cladding/Core/Upper Cladding on Substrate

To 100 parts by mass of organopolysiloxane C above, 2.0 parts by mass of 2-benzyl-2-(dimethylamino)-4'-morpholinobutyrophenone (Omnirad 369, available from IGM Resins B.V.) as a photopolymerization initiator and 20 parts by mass of propylene glycol monomethyl ether acetate as an organic solvent were added. The mixture was stirred at room temperature. This composition was designated as a seventh curable polymer composition. The silicon wafer substrate surface on which the lower cladding and the core were produced as obtained in Example 9 was subjected to plasma treatment, and the seventh curable polymer composition was applied by spin coating. Thereafter, the solvent was removed by reduced pressure treatment, followed by exposure with an exposure device (intensity at a wavelength of 365 nm: 40 $mW/cm^2$, integrated light quantity: 1000 $mJ/cm^2$). After heating at 130°C for 10 minutes, the insufficiently cured portion of the coating film surface was washed away using propylene glycol monomethyl ether acetate and subsequently using 2-propanol. Then, heating was performed in a heating furnace at 130°C for 30 seconds, followed by further heating in a heating furnace at 150°C for 1 hour, to thereby produce an optical waveguide having the lower cladding formed of the fifth curable polymer composition, the core formed of the sixth curable polymer composition, and an upper cladding formed of the seventh curable polymer composition on the silicon wafer substrate.

FIG. 4 is a schematic cross-sectional view of the optical waveguide produced in Example 10.

Discussion of Results

In Examples 1 to 3, in which the coefficient in Formula [1] is $Q > 0$, the cured products have refractive indices of 1.437 to 1.452 at a wavelength of 589 nm, and the connection loss can become smaller when connected to near-infrared single mode quartz-based optical fibers. The cured products produced from the organopolysiloxane compositions of Examples 1 to 6 have refractive indices of 1.429 to 1.453 at a wavelength of 1300 nm and 1.426 to 1.452 at a wavelength of 1550 nm, and the use of the cured products as a core material for a near-infrared optical waveguide enables the connection loss to become smaller when connected to near-infrared single-mode quartz-based optical fibers. In addition, the cured products are also useful as a cladding material used around a core material having a refractive index of about 1.400 to 1.500 at a wavelength of 1300 nm. Furthermore, the cured products produced from the organopolysiloxane compositions of Examples 1 to 6 have a 1% weight loss temperature of 284°C or higher or a 5% weight loss temperature of 330°C or

higher, and have high reflow resistance. Therefore, it was confirmed that an optical waveguide can be formed using the cured products by photolithography. In Examples 7 to 10, various optical waveguides were actually produced.

From Reference Examples 1 to 3, it was confirmed that the compositions containing the organopolysiloxanes having the compositions have refractive indices of 1.470 or less at a wavelength of 1300 nm, and they are also excellent in heat resistance and suitable for near-infrared optical waveguide applications. In addition, from Reference Example 3, it was also confirmed that the addition of the chain transfer agent improves the curability and improves the heat resistance of the cured product.

In Comparative Example 1, in which the coefficient in Formula [1] is Q = 0, the cured product has a refractive index of more than 1.5, and the connection loss can be larger when connected to near-infrared single-mode quartz-based optical fibers. In addition, the cured product has a 1% weight loss temperature of 285°C or lower, and does not have sufficient reflow resistance. Furthermore, in Comparative Example 2, in which the coefficient in Formula [1] is Q = 0, the cured product has a refractive index of 1.476 at a wavelength of 589 nm, and the connection loss can become smaller when connected to near-infrared single-mode quartz-based optical fibers. However, the cured product has a 1% weight loss temperature of 285°C or lower, and does not have sufficient reflow resistance.

## Industrial Applicability

The optical waveguide produced according to the present production method has a superior microfabrication property and heat resistance, and can reduce the connection loss due to reflection at the interface between an optical fiber and the optical waveguide.

Therefore, the organopolysiloxanes in both aspects of the present invention are useful as a material for forming a near-infrared optical waveguide. In addition, from the viewpoint of optical properties, heat resistance, and a patterning property by lithography, applications can be expected as an optical waveguide to be connected to a non-quartz-based optical fiber having a core material with a refractive index of about 1.4 to 1.5, and as an optical adhesive used for a connection portion between an optical waveguide and an optical fiber.

## Reference Signs List

- 10 Substrate
- 20 Lower cladding layer
- 30 Upper cladding layer
- 40 Core

## Claims

**1.** An organopolysiloxane represented by General Formula [1]:

$$(R^1R^2R^3SiO_{1/2})_{M1}(R^4R^5R^6SiO_{1/2})_{M2}\ (R^7R^8SiO_{2/2})_{D1}(R^9R^6SiO_{2/2})_{D2}\ (R^{10}SiO_{3/2})_{T1}(R^6SiO_{3/2})_{T2}\ (SiO_{4/2})_Q\ (O_{1/2}R^{11})_{Y1}(O_{1/2}R^6)_{Y2} \quad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;

$$0 \leq M1, D1, T1, Y1, Y2;$$

$$0 < Q;$$

$$0 < M2 + D2 + T2 \leq 0.25;$$

$$0.05 < Y1;$$

and

$$M1 + M2 + D1 + D2 + T1 + T2 + Q = 1].$$

**2.** A non-linear organopolysiloxane represented by General Formula [21] and having no aromatic structure:

$$(R^{2-1}R^{2-2}R^{2-3}SiO_{1/2})_{M1}(R^{2-4}R^{2-5}R^{2-6}SiO_{1/2})_{M2}(R^{2-7}R^{2-8}SiO_{2/2})_{D1}(R^{2-9}R^{2-6}SiO_{2/2})_{D2}(R^{2-10}SiO_{3/2})_{T1}(R^{2-6}SiO_{3/2})_{T2}(SiO_{4/2})_{Q1}(O_{1/2}R^{2-11})_{Y1}(O_{1/2}R^{2-6})_{Y2} \quad [21]$$

[in Formula [21], $R^{2-1}$ to $R^{2-5}$ and $R^{2-7}$ to $R^{2-11}$ are each independently one or two or more groups selected from an organic group, a reactive functional group, and a hydrogen atom;
$R^{2-1}$ to $R^{2-3}$, $R^{2-7}$, $R^{2-8}$, $R^{2-10}$, and $R^{2-11}$ do not contain a polymerizable alkenyl group;
$R^{2-6}$ is one or two or more organic groups containing a polymerizable alkenyl group, which are optionally the same or different;

$$0 \leq M1, D1, T1, Y1, Y2;$$

$$0 < M2 + D2 + T2 \leq 0.25;$$

$$0.05 < Y1;$$

and

$$M1 + M2 + D1 + D2 + T1 + T2 + Q = 1].$$

**3.** The organopolysiloxane according to claim 1 or 2, wherein $0.12 < M2 + D2 + T2 \leq 0.25$ in Formula [1] or Formula [21].

**4.** The organopolysiloxane according to claim 1 or 2, wherein $Y1 \leq 0.25$ in Formula [1] or Formula [21].

**5.** The organopolysiloxane according to claim 2, wherein $0 < Q$ in Formula [21].

**6.** The organopolysiloxane according to claim 1 or 5, wherein $0.04 \leq Q$ in Formula [1] or Formula [21].

**7.** The organopolysiloxane according to claim 1 or 2, wherein $M1 + M2 < 0.50$ in Formula [1] or Formula [21].

**8.** The organopolysiloxane according to claim 1, wherein the organopolysiloxane does not have an aromatic structure.

**9.** The organopolysiloxane according to claim 1 or 2, wherein

in Formula [1] or Formula [21], $R^6$ or $R^{2-6}$ has, in one molecule, one or more functional groups selected from the group represented by Formulae [2] to [5]:

[Chem. 1]

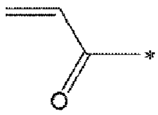 [2] 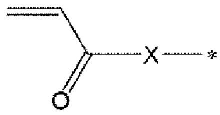 [3]

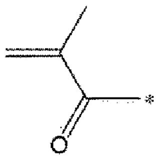 [4] 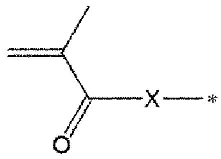 [5]

(in Formulae described above, X is a divalent organic group, and optionally contains a branched structure and/or a cyclic structure; when X is bonded to a silicon atom, an atom that is at a terminal of X and is directly bonded to silicon is a carbon atom; when X is bonded to an oxygen atom directly bonded to silicon, an atom that is at a terminal of X and is directly bonded to the oxygen atom is a carbon atom; and * represents a bond).

**10.** The organopolysiloxane according to claim 1 or 2, wherein
$R^6$ or $R^{2-6}$ is a (meth)acryloyloxypropyl group.

**11.** An organopolysiloxane composition comprising the organopolysiloxane described in claim 1 or 2, and at least a polymerization initiator.

**12.** A cured product produced by curing the organopolysiloxane composition described in claim 11.

**13.** A near-infrared optical waveguide produced using the organopolysiloxane composition described in claim 11.

**14.** A near-infrared optical waveguide comprising a core and a cladding, wherein
the core and the cladding are produced using the organopolysiloxane composition described in claim 11.

**15.** A near-infrared optical transmission member comprising at least the near-infrared optical waveguide described in claim 13.

**16.** A near-infrared optical transmission member comprising at least the near-infrared optical waveguide described in claim 14.

**17.** A method for producing a near-infrared optical waveguide, the method comprising:

(i-1) applying a first curable polymer composition to a surface of a substrate to form a first polymer layer;
(i-2) irradiating at least one selected region of the first polymer layer with an active energy ray having a wavelength of 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane composition described in claim 11.

**18.** The method for producing a near-infrared optical waveguide according to claim 17, further comprising:

(i-4) coating the surface of the substrate and the core with a second curable polymer composition to form a second polymer layer; and
(i-5) curing the second polymer layer to form an upper cladding.

**19.** The method for producing a near-infrared optical waveguide according to claim 18, wherein
the second curable polymer composition is the organopolysiloxane composition described in claim 11.

**20.** A method for producing a near-infrared optical waveguide, the method comprising:

(ii-1) applying a third curable polymer composition to a surface of a substrate to form a third polymer layer;
(ii-2) irradiating at least one selected region of the third polymer layer with an active energy ray having a wavelength of 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane composition described in claim 11.

**21.** The method for producing a near-infrared optical waveguide according to claim 20, wherein both of the third curable polymer composition and the fourth curable polymer composition are the organopolysiloxane composition described in claim 11.

**22.** A method for producing a near-infrared optical waveguide, the method comprising:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane composition described in claim 11.

**23.** The method for producing a near-infrared optical waveguide according to claim 22, wherein both of the fifth curable polymer composition and the sixth curable polymer composition are the organopolysiloxane composition described in claim 11.

**24.** A method for producing a near-infrared optical waveguide, the method comprising:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane composition described in claim 11.

**25.** The method for producing a near-infrared optical waveguide according to claim 24, wherein all of the fifth curable polymer composition, the sixth curable polymer composition, and the seventh curable polymer composition are the organopolysiloxane composition described in claim 11.

**26.** An organopolysiloxane for a near-infrared optical waveguide, the organopolysiloxane comprising an organic group containing a polymerizable alkenyl group, and Q unit silicon ($SiO_{4/2}$), and comprising no aromatic structure.

**27.** The organopolysiloxane for a near-infrared optical waveguide according to claim 26, wherein

the organopolysiloxane is represented by General Formula [1]:

$$(R^1R^2R^3SiO_{1/2})_{M1}(R^4R^5R^6SiO_{1/2})_{M2} \quad (R^7R^8SiO_{2/2})_{D1}(R^9R^6SiO_{2/2})_{D2} \quad (R^{10}SiO_{3/2})_{T1} (R^6SiO_{3/2})_{T2}(SiO_{4/2})_Q (O_{1/2}R^{11})_{Y1}(O_{1/2}R^6)_{Y2} \qquad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;

$$0 \leq M1, D1, T1, Y1, Y2;$$

$$0 < Q; 0 < M2 + D2 + T2;$$

and

$$M1 + M2 + D1 + D2 + T1 + T2 + Q = 1].$$

**28.** The organopolysiloxane for a near-infrared optical waveguide according to claim 27, wherein $0 < M2 + D2 + T2 \leq 0.25$ in Formula [1].

**29.** The organopolysiloxane for a near-infrared optical waveguide according to claim 27, wherein $0.02 \leq Y1 \leq 0.25$ in Formula [1].

**30.** The organopolysiloxane for a near-infrared optical waveguide according to claim 27, wherein $0.04 \leq Q$ in Formula [1].

**31.** The organopolysiloxane for a near-infrared optical waveguide according to claim 27, wherein $M1 + M2 < 0.50$ in Formula [1].

**32.** The organopolysiloxane for a near-infrared optical waveguide according to claim 27, wherein

in Formula [1], $R^6$ has, in one molecule, one or two or more functional groups selected from the group represented by Formulae [2] to [5]:

[Chem. 2]

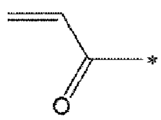

[2]

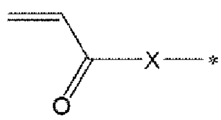

[3]

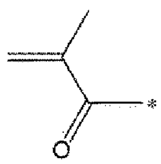

[4]

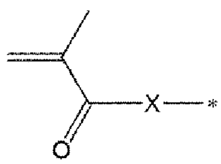

[5]

(wherein X is a divalent organic group that optionally contains a branched structure and/or a cyclic structure; when a silicon atom is bonded to X, an atom that is at a terminal of X and is directly bonded to silicon is a carbon atom; when an oxygen atom directly bonded to silicon is bonded to X, an atom that is at a terminal of X and is directly bonded to the oxygen atom is a carbon atom; and * represents a bond).

**33.** The organopolysiloxane for a near-infrared optical waveguide according to claim 27, wherein

$R^6$ is a (meth)acryloyloxypropyl group.

**34.** An organopolysiloxane composition for a near-infrared optical waveguide, the organopolysiloxane composition comprising the organopolysiloxane for a near-infrared optical waveguide described in any one of claims 26 to 33, and at least a polymerization initiator.

**35.** A cured product for a near-infrared optical waveguide, the cured product being produced by curing the organopolysiloxane composition for a near-infrared optical waveguide described in claim 34.

**36.** A near-infrared optical waveguide produced using the organopolysiloxane composition for a near-infrared optical waveguide described in claim 34.

**37.** A near-infrared optical waveguide comprising a core and a cladding, wherein
the core and the cladding are produced using the organopolysiloxane composition for a near-infrared optical waveguide described in claim 34.

**38.** A near-infrared optical transmission member comprising at least the near-infrared optical waveguide described in claim 36.

**39.** A near-infrared optical transmission member comprising at least the near-infrared optical waveguide described in claim 37.

**40.** A method for producing a near-infrared optical waveguide, the method comprising:

(i-1) applying a first curable polymer composition to a surface of a substrate to form a first polymer layer;
(i-2) irradiating at least one selected region of the first polymer layer with an active energy ray having a wavelength of 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane composition for a near-infrared optical waveguide described in claim 34.

**41.** The method for producing a near-infrared optical waveguide according to claim 40, further comprising:

(i-4) coating the surface of the substrate and the core with a second curable polymer composition to form a second polymer layer; and
(i-5) curing the second polymer layer to form an upper cladding.

**42.** The method for producing a near-infrared optical waveguide according to claim 41, wherein
the second curable polymer composition is the organopolysiloxane composition for a near-infrared waveguide described in claim 34.

**43.** A method for producing a near-infrared optical waveguide, the method comprising:

(ii-1) applying a third curable polymer composition to a surface of a substrate to form a third polymer layer;
(ii-2) irradiating at least one selected region of the third polymer layer with an active energy ray having a wavelength of 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane composition for a near-infrared waveguide described in claim 34.

**44.** The method for producing a near-infrared optical waveguide according to claim 43, wherein
both of the third curable polymer composition and the fourth curable polymer composition are the organopolysiloxane composition for a near-infrared waveguide described in claim 34.

**45.** A method for producing a near-infrared optical waveguide, the method comprising:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane composition for a near-infrared optical waveguide described in claim 34.

**46.** The method for producing a near-infrared optical waveguide according to claim 45, wherein
both of the fifth curable polymer composition and the sixth curable polymer composition are the organopolysiloxane composition for a near-infrared optical waveguide described in claim 34.

**47.** A method for producing a near-infrared optical waveguide, the method comprising:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane composition for a near-infrared optical waveguide described in claim 34.

**48.** The method for producing a near-infrared optical waveguide according to claim 47, wherein
all of the fifth curable polymer composition, the sixth curable polymer composition, and the seventh curable polymer composition are the organopolysiloxane composition for a near-infrared optical waveguide described in claim 34.

Fig. 1

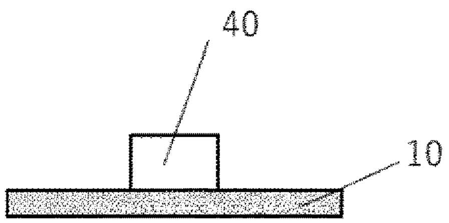


Fig. 2

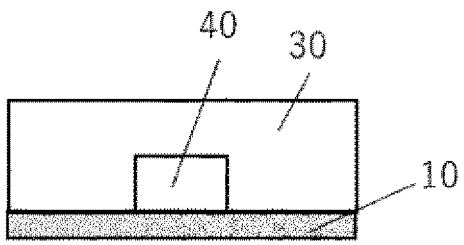


Fig. 3

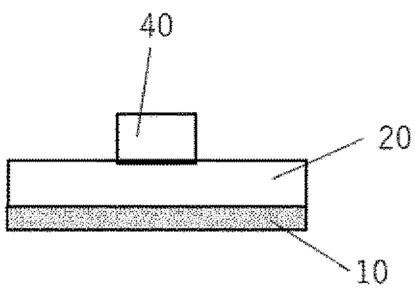


Fig. 4

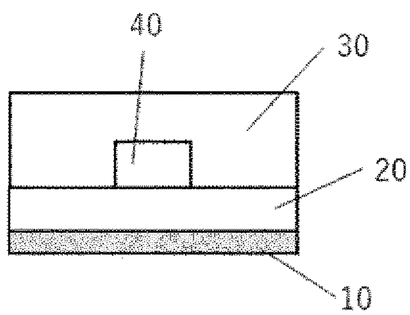

## INTERNATIONAL SEARCH REPORT

International application No.
**PCT/JP2024/032122**

**A. CLASSIFICATION OF SUBJECT MATTER**

***C08G 77/20***(2006.01)i; ***C08F 299/08***(2006.01)i; ***G02B 6/12***(2006.01)i; ***G02B 6/13***(2006.01)i
FI: C08G77/20; C08F299/08; G02B6/12 371; G02B6/13

According to International Patent Classification (IPC) or to both national classification and IPC

**B. FIELDS SEARCHED**

Minimum documentation searched (classification system followed by classification symbols)

C08G77/20; C08F299/08; G02B6/12; G02B6/13

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2022-157239 A (MITSUBISHI CHEMICAL CORPORATION) 14 October 2022 (2022-10-14)<br>claims, examples | 1-48 |
| X | JP 2018-95729 A (MITSUBISHI CHEMICAL CORPORATION) 21 June 2018 (2018-06-21)<br>claims, examples | 1-48 |
| X | JP 2005-227701 A (DOW CORNING CORPORATION) 25 August 2005 (2005-08-25)<br>claims, examples | 1-8, 12, 26-31 |
| A | | 9-11, 13-25, 32-48 |
| A | JP 2019-104836 A (SHIN-ETSU CHEMICAL CO., LTD.) 27 June 2019 (2019-06-27)<br>claims, examples | 1-48 |
| A | JP 2003-227949 A (SHIN-ETSU CHEMICAL CO., LTD.) 15 August 2003 (2003-08-15)<br>claims, examples | 1-48 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 November 2024** | **19 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No. PCT/JP2024/032122

**Box No. III Observations where unity of invention is lacking (Continuation of item 3 of first sheet)**

This International Searching Authority found multiple inventions in this international application, as follows:

Invention 1: Claims 1, 5-6, 8, and 27-33, claims 3-4, 7, and 9-25, which refer back to claim 1, and claims 34-48, which refer back to any one of claims 27-33

Since claims 1, 5-6, 8, and 27-33, claims 3-4, 7, and 9-25, which refer back to claim 1, and claims 34-48, which refer back to any one of claims 27-33 have the special technical feature, wherein an organopolysiloxane "is represented by general formula [1]," the claims are classified as invention 1.

Invention 2: Claim 2 and claims 3-4, 7, and 9-25, which refer back to claim 2

Claim 2 and claims 3-4, 7, and 9-25, which refer back to claim 2 share with claims 1, 5-6, 8, and 27-33, claims 3-4, 7, and 9-25, which refer back to claim 1, and claims 34-48, which refer back to any one of claims 27-33, classified as invention 1, the common technical feature of "an organopolysiloxane."

However, this technical feature is so publicly known that it is not necessary to provide any document thereof, and does not make a contribution over the prior art. Therefore, said technical feature cannot be said to be a special technical feature. Moreover, there is no other same or corresponding special technical feature among these inventions.

Furthermore, claim 2 and claims 3-4, 7, and 9-25, which refer back to claim 2 do not depend from claim 1. In addition, claim 2 and claims 3-4, 7, and 9-25, which refer back to claim 2, are not substantially identical to or similarly closely related to any of the claims classified as invention 1.

Accordingly, claim 2 and claims 3-4, 7, and 9-25, which refer back to claim 2, cannot be classified as invention 1.

Since claim 2 and claims 3-4, 7, and 9-25, which refer back to claim 2, have the special technical feature, wherein the organopolysiloxane "is represented by general formula [21] and is a nonlinear chain, which does not have an aromatic structure," the claims are classified as invention 2.

Invention 3: Claim 26 and claims 34-48, which refer back to claim 26

Claim 26 and claims 34-48, which refer back to claim 26, share with claims 1, 5-6, 8, and 27-33, claims 3-4, 7, and 9-25, which refer back to claim 1, and claims 34-48, which refer back to any one of claims 27-33, classified as invention 1, the common technical feature of an organopolysiloxane, "which has a polymerizable alkenyl group-containing organic group and Q unit silicon ($SiO_{4/2}$)."

Claim 26 and claims 34-48, which refer back to claim 26, also share with claim 2 and claims 3-4, 7, and 9-25, which refer back to claim 2, classified as invention 2, the common technical feature of an organopolysiloxane, "which has a polymerizable alkenyl group-containing organic group and does not have an aromatic structure."

However, this feature is so publicly known that it is not necessary to provide any document thereof, and does not make a contribution over the prior art. Therefore, said technical feature cannot be said to be a special technical feature. Moreover, there is no other same or corresponding special technical feature among these inventions.

Furthermore, claim 26 and claims 34-48, which refer back to claim 25, do not depend from claims 1 or 2. In addition, claim 26 and claims 34-48, which refer back to claim 26, are not substantially identical to or similarly closely related to any of the claims classified as invention 1 or 2.

Accordingly, claim 26 and claims 34-48, which refer back to claim 26, cannot be classified as invention 1 or invention 2.

Since claim 26 and claims 34-48, which refer back to claim 26, have the special technical feature, wherein the organopolysiloxane "has a polymerizable alkenyl group-containing organic group and Q unit silicon ($SiO_{4/2}$) and does not have an aromatic structure," the claims are classified as invention 3.

**INTERNATIONAL SEARCH REPORT**

International application No.
**PCT/JP2024/032122**

**Box No. III Observations where unity of invention is lacking (Continuation of item 3 of first sheet)**

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

**INTERNATIONAL SEARCH REPORT**
**Information on patent family members**

International application No.
**PCT/JP2024/032122**

| Patent document cited in search report | Publication date (day/month/year) | Patent family member(s) | Publication date (day/month/year) |
|---|---|---|---|
| JP 2022-157239 A | 14 October 2022 | (Family: none) | |
| JP 2018-95729 A | 21 June 2018 | US 2019/0292320 A1<br>claims, examples<br>JP 2022-10421 A<br>US 2023/0250237 A1<br>WO 2018/110613 A1<br>EP 3556795 A1<br>CN 110072919 A<br>KR 10-2019-0091517 A | |
| JP 2005-227701 A | 25 August 2005 | (Family: none) | |
| JP 2019-104836 A | 27 June 2019 | CN 109912797 A<br>KR 10-2019-0070869 A | |
| JP 2003-227949 A | 15 August 2003 | US 2003/0148226 A1<br>claims, examples<br>US 2005/0025442 A1 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005163009 A
- WO 2001004186 A
- JP 2014510159 A